Europäisches Patentamt

European Patent Office

Office européen des brevets

(19)

(11) **EP 1 307 753 B1**

(12) **EUROPÄISCHE PATENTSCHRIFT**

(45) Veröffentlichungstag und Bekanntmachung des
Hinweises auf die Patenterteilung:
**19.10.2005   Patentblatt 2005/42**

(21) Anmeldenummer: **01980233.9**

(22) Anmeldetag: **06.08.2001**

(51) Int Cl.⁷: **H02H 9/08**

(86) Internationale Anmeldenummer:
**PCT/EP2001/009056**

(87) Internationale Veröffentlichungsnummer:
**WO 2002/015355 (21.02.2002 Gazette 2002/08)**

(54) **VERFAHREN UND VORRICHTUNG ZUR ERKENNUNG UND ORTUNG VON HOCHOHMIGEN EINPOLIGEN ERDFEHLERN**

METHOD AND DEVICE FOR IDENTIFYING AND LOCALISING HIGH-OHM, SINGLE-POLE EARTH FAULTS

PROCEDE ET DISPOSITIF POUR RECONNAITRE ET LOCALISER DES DEFAUTS A LA TERRE MONOPOLAIRES A VALEUR OHMIQUE ELEVEE

(84) Benannte Vertragsstaaten:
**AT BE CH CY DE DK ES FI FR GB GR IE IT LI LU MC NL PT SE TR**

(30) Priorität: **11.08.2000  AT  13972000**

(43) Veröffentlichungstag der Anmeldung:
**07.05.2003   Patentblatt 2003/19**

(73) Patentinhaber: **Adaptive Regelsysteme
Gesellschaft mbH
5020 Salzburg (AT)**

(72) Erfinder: **LEIKERMOSER, Albert
A-5020 Salzburg (AT)**

(74) Vertreter: **VA TECH Patente GmbH & Co
Penzinger Strasse 76
1141 Wien (AT)**

(56) Entgegenhaltungen:
DE-A- 2 458 530          DE-C- 627 134
US-A- 4 224 652

Anmerkung: Innerhalb von neun Monaten nach der Bekanntmachung des Hinweises auf die Erteilung des europäischen Patents  kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung beschreibt ein Verfahren zur selektiven Erkennung und Ortung von hochohmigen einpoligen Erdfehlern in sternpunktkompensierten elektrischen Versorgungsnetzen, bei dem in das Nullsystem des Netzes zumindest ein Hilfssignal mit der Netzfrequenz $\omega_N$ eingespeist wird, sowie eine aus einem Signalgenerator zur Erzeugung zumindest eines Hilfssignals mit der Netzfrequenz $\omega_N$ und einer Regeleinheit zum Erkennen und Orten von einpoligen Erdfehlern bestehende Einrichtung zum Ausführen des Verfahrens.

Die DE 24 58 530 A1 beschreibt eine Erdschluss-Überwachungseinrichtung für elektrische Netze, wobei zwischen dem zu überwachendem System und der Erde eine Zusatzspannungsquelle mit mindestens einer von der Netzfrequenz verschiedenen Frequenz eingeschaltet wird. Dabei wird in das überwachte System ein Signal mit einer typischen Signalform, die unterschiedlich von allen zu erwartenden Störsignalen ist, eingespeist, die eine Verlagerungsspannung und in weiterer Folge einen Strom mit der eingespeisten Signalform zur Folge hat. Eine Vergleichseinrichtung erkennt diese Signalform. Im Falle eines Erdschlusses bewirkt die Verlagerungsspannung eine Stromerhöhung, durch die eine Auslöseeinrichtung aktiviert wird, wenn der Strom einen bestimmten Grenzwert überschreitet. Bei höher- bis hochohmigen Erdfehlern, im Bereich von einigen zehn Kiloohm aufwärts, wie sie zum Beispiel durch das Berühren einer Phasenleitung mit dem Ast eines Baumes entstehen können, liegen die Fehlerströme aber größenmäßig im Bereich der Unsymmetrieströme des Netzes. Dies kann dazu führen, dass die Amplitude des netzfrequenten Anteiles der Verlagerungsspannung beim Eintritt von derartig hochohmigen Erdfehlern sogar sinkt, anstatt, wie dies bei niederohmigeren Erdfehlern der Fall ist, anzusteigen. Doch damit kann dieses Verfahren für hochohmige Erdfehler nicht oder nur unsicher funktionieren.

Die Erfindung stellt sich die Aufgabe, ein Verfahren und eine zugehörige Vorrichtung der eingangs genannten Art zu schaffen mit dem es möglich ist, sehr hochohmige, einpolige Erdfehler sicher und zuverlässig zu erkennen und zu orten.

Die Aufgabe ist für das Verfahren dadurch gelöst, dass das Hilfssignal so eingespeist wird, dass dadurch die Sternpunkt-Verlagerungsspannung $U_{ne}(\omega_N)$ bei Netzfrequenz $\omega_N$, also die Spannung zwischen dem Sternpunkt des Speisetransformators des Netzes bzw. der Löschspule und der Erde, im Wesentlichen kompensiert wird und dass Erdfehler bei durch das Hilfssignal kompensierter Sternpunkt-Verlagerungsspannung $U_{ne}(\omega_N)$ erkannt und geortet werden. Für die Vorrichtung ist die oben gestellte Aufgabe dadurch gelöst, dass ein Element des Netzes, beispielsweise die Löschspule, vorzugsweise eine Tauchkernspule, mit diesem Hilfssignal beaufschlagbar ist und dass der Signalgenerator zur Kompensation der Sternpunkt-Verlagerungsspannung $U_{ne}(\omega_N)$ mittels des erzeugten Hilfssignals vorgesehen ist und dass eine Regeleinheit (4) zur Erkennung und Ortung eines Erdfehlers bei durch das Hilfssignal kompensierter Sternpunkt-Verlagerungsspannung $U_{ne}(\omega_N)$ vorgesehen ist.

Bei dem erfindungsgemäßen Verfahren wird zum ersten Mal die Sternpunkt-Verlagerungsspannung bezüglich des netzfrequenten Anteils zur Erkennung und Ortung von Erdfehlern zu-Null kompensiert, womit im Nullsystem die in Versorgungsnetzen eigentlich nicht erwünschte Sternpunkt-Verlagerungsspannung verschwindet. Darüber hinaus können durch diese Kompensation auch sehr hochohmige Erdfehler mit sehr einfachen Mitteln, sehr selektiv und zuverlässig geortet werden, da im Fall von hochohmigen einpoligen Erdfehlern bei kompensierter Sternpunkt-Verlagerungsspannung gleichzeitig der zu ortende Fehlerstrom erhöht wird und somit die Selektivität und Sicherheit der Ortung verbessert wird.

Für den Betrieb eines elektrischen Versorgungsnetzes ist es sehr vorteilhaft keine Sternpunkt-Verlagerungsspannung $U_{ne}(\omega_N)$ bei Netzfrequenz zu haben. Dies wird erfindungsgemäß erreicht, indem das beispielsweise in Form eines Stromes eingespeiste Hilfssignal bei Netzfrequenz $i_{vC}(\omega_N)$ durch eine Regeleinheit in Betrag und Phase so gesteuert wird, dass die Summe aus diesem eingespeisten Hilfssignal und dem natürlichen Verlagerungsstrom, also der Summe der Unsymmetrieströme aller Abzweige oder Leitungsabschnitte des Netzes, im Wesentlichen gleich Null wird. Durch eine derartige Einspeisung eines solchen Hilfssignales erreicht man durch die Kompensation der Unsymmetrieströme des Gesamtnetzes in Folge natürlich eine Kompensation der Sternpunkt-Verlagerungsspannung $U_{ne}(\omega_N)$. Diese wird bezüglich der Netzfrequenzanteile also Null.

Für das Verfahren ist es sehr vorteilhaft, dass durch Messen des eingespeisten Stromes bei Netzfrequenz $i_{vC}(\omega_N)$ im eingeregelten Zustand, also bei $i_{vC}(\omega_N) + i_{vS}(\omega_N) = 0$, indirekt der natürliche Verlagerungsstrom $i_{vS}(\omega_N)$, also die Summe der Unsymmetrieströme aller Abzweige oder Leitungsabschnitte des Netzes, gemessen wird und dass mit diesem gemessenen Strom $i_{vC}(\omega_N)$ ein Erdfehler im Gesamtnetz erkannt wird. Dadurch kann ein Erdfehler erkannt und angezeigt werden, wenn der Messwert des einzuspeisenden Stromes bei Netzfrequenz $i_{vC}(\omega_N)$, vorzugsweise die Amplitude, der Betrag oder der Effektivwert, stark ansteigt und eine vordefinierte Fehlerschwelle überschreitet. Alternativ dazu kann ein Erdfehler erkannt und angezeigt werden, wenn der Betrag der komplexen Differenz zweier zeitlich aufeinanderfolgender Messungen des einzuspeisenden Stromes bei Netzfrequenz $i_{vC}(\omega_N)$ (jeweils im eingeregelten Zustand) stark ansteigt und eine vordefinierte Fehlerschwelle überschreitet. Beide Möglichkeiten können mit sehr einfachen Mitteln umgesetzt werden und bieten eine sehr zuverlässige Erkennung von Erdfehlern.

Damit kann in weiterer Folge auch sehr einfach der fehlerhafte Abzweig oder Leitungsabschnitt des Netzes gefunden werden, da durch Messen des Nullstromes $i_0^{(k)}(\omega_N)$ im eingeregelten Zustand, also bei $U_{ne}(\omega_N) = 0$, von jedem Abzweig oder Leitungsabschnitt $k$ des Netzes bei Netzfrequenz $\omega_N$ direkt die Summe aus dem natürlichen Verlagerungsstrom $i_v^{(k)}(\omega_N)$ und einem eventuell vorhandenen Fehlerstrom des jeweiligen $k$ - $ten$ Abzweiges oder Leitungsabschnittes bei Netzfrequenz gemessen wird und diese Nullströme $i_0^{(k)}(\omega_N)$ zur Bestimmung des fehlerhaften Abzweiges oder Leitungsabschnittes des Netzes und/oder der fehlerhaften Stelle innerhalb dieses Abzweiges oder Leitungsabschnittes herangezogen werden können. Ein sehr einfaches Verfahren ergibt sich, wenn für einen (am besten für jeden) Abzweig oder Leitungsabschnitt $f$ der zugehörige Nullstrom $i_0^{(f)}(\omega_N)$, vorzugsweise die Amplitude, der Betrag oder der Effektivwert, mit einer vordefinierten Fehlerschwelle verglichen und als fehlerhaft erkannt und angezeigt wird, wenn der Betrag des komplexen Nullstromvektors $i_0^{(f)}(\omega_N)$ diese Fehlerschwelle für eine vordefinierte Zeit überschreitet. Eine mögliche Alternative ergibt sich, wenn für einen (am besten für jeden) Abzweig oder Leitungsabschnitt $f$ von zwei zeitlich aufeinanderfolgenden Messungen des zugehörigen Nullstromes $i_0^{(f)}(\omega_N)$ (jeweils im eingeregelten Zustand) die komplexe Differenz gebildet, der Betrag dieser Differenz mit einer vordefinierten Fehlerschwelle verglichen und ein fehlerhafter Abzweig oder Leitungsabschnitt erkannt und angezeigt wird, wenn der Betrag der Differenz diese Fehlerschwelle überschreitet. Man erhält also in Summe ein sehr einfach zu implementierendes und wenig aufwendiges Verfahren zur Erkennung und Ortung von auch sehr hochhohmigen Erdfehlern, das zusätzlich noch mit einer sehr hohen Selektivität betrieben werden kann.

Für den Fall, dass der Verlagerungsstrom (Unsymmetriestrom) des Gesamtnetzes, indirekt also der Fehlerstrom, so stark ansteigt, dass er durch den eingespeisten Strom nicht mehr kompensiert werden kann, ist es ganz besonders vorteilhaft, wenn man auf ein anderes geeigneteres Verfahren zur Ortung von Erdfehlern umschalten kann, da dann die Fehlerortung weiterhin gewährleistet bleibt.

Ganz besonders einfach und in vorteilhafter Weise lässt sich das erfindungsgemäße Verfahren zur Erkennung und Ortung von hochohmigen Erdfehlern mit einem Verfahren zur Abstimmung einer Löschspule verbinden, indem zumindest ein weiteres Hilfssignal mit einer Frequenz $\omega_i$ ungleich der Netzfrequenz $\omega_N$ eingespeist wird und dieses Hilfssignal zur Abstimmung der Löschspule verwendet wird. Somit kann trotz kompensierter Sternpunkt-Verlagerungsspannung bei Netzfrequenz die Löschspule auf das Netz kontinuierlich abgestimmt, können also Schalthandlungen im Netz erkannt werden und zusätzlich noch die Erkennung und Ortung von Erdfehlern sichergestellt werden.

Zur Abstimmung der Löschspule ist es besonders günstig, das zum Beispiel in Form eines elektrischen Stromes eingespeiste Hilfssignal $i_{vC}(\omega_1)$ und die daraus entstehende Sternpunkt-Verlagerungsspannung $U_{ne}(\omega_1)$ bezüglich einer Frequenz $\omega_1$, ungleich der Netzfrequenz $\omega_N$, beispielsweise $\omega_1 = \frac{\omega_N}{2}$ oder $\omega_1 = \frac{3\omega_N}{2}$, kontinuierlich nach Betrag und Phase zu messen, und durch Quotientenbildung von $i_{vC}(\omega_1)$ und $U_{ne}(\omega_1)$ die Admittanzsumme, aus der Erdadmittanz aller Abzweige oder Leitungsabschnitte des Netzes $Y_S(\omega_1)$ und der Löschspulenadmittanz $Y_L(\omega_1)$ zu bestimmen und daraus in weiterer Folge die Netzparameter Summenkapazität $C_s$ und die Leitwertsumme aus dem Summenleitwert $g_s$ des Gesamtnetzes und dem Spulenleitwert $g_L$ der Löschspule zu bestimmen. Alternativ dazu können diese Netzparameter auch aus den Messwerten bei mehreren Frequenzen $\omega_i$, ungleich der Netzfrequenz $\omega_N$, bestimmt werden, wobei aus der Menge der einzelnen Frequenzanteile der Messwerte durch eine bestmögliche Approximation im Sinne der Minimierung einer Fehlerfunktion die bestapproximierenden Netzparameter ermittelt werden. Dadurch ist man erstmals in der Lage, ohne Verstellen der Löschspule und auch ohne Änderung des natürlichen oder künstlichen Unsymmetriestromanteiles im Nullsystem alle zur Abstimmung der Löschspule notwendigen Netzparameter kontinuierlich und auf sehr einfache Weise bestimmen zu können.

Ganz besonders vorteilhaft ist es, die Größen der Hilfssignale mit einer Frequenz $\omega_i$ ungleich der Netzfrequenz $\omega_N$ so zu wählen, dass die Effektivwerte der daraus resultierenden Sternpunkt-Verlagerungsspannung $U_{ne}(\omega_i)$ bei dieser Frequenz vergleichsweise klein, vorzugsweise kleiner 10% des Effektivwertes der Grundwelle der Phasennennspannung des Netzes wird, da dann diese kleinen Überlagerungen der Netzspannung im Nullsystem vernachlässigbar sind.

Ganz besonders selektiv und genau wird das Verfahren, wenn die Frequenzen $\omega_i$ so gewählt werden, dass sich die Grundwellenanteile und auch die Oberwellenanteile der Frequenzspektren aller eingespeisten Signale mit den Grundwellenkreisfrequenzen $\omega_i$ und $\omega_N$ nicht überschneiden, da dann jedes Einspeisesignal für sich alleine betrachtet werden darf und sich keine Überlagerungen von Signalen mit unterschiedlicher Grundwellenfrequenz bezüglich ihrer Grund - oder Oberwellenspektren im Zusammenhang mit der Fourierreihenzerlegung oder Fouriertransformation ergeben. Damit wird speziell sichergestellt, dass die zur Resonanzabstimmung, bzw. Netzparameterermittlung verwendeten Frequenzanteile in keinen ganzzahlig ungeradzahligem Verhältnis mit der Netzfrequenz stehen und damit ausgeschlossen werden kann, dass die natürlichen Unsymmetrien des Netzes in Form von Unsymmetrieströmen das Abstimmungsergebnis, bzw. das Ergebnis der Netzparameterermittlung beeinflussen können.

Mit den bekannten Netzparametern kann die Löschspule für das Netz bei Netzfrequenz $\omega_N$ abgestimmt werden. Dies kann durchgeführt werden, indem mit der Summenkapazität $C_S$ des Gesamtnetzes der Resonanzpunkt bei Netzfrequenz $\omega_N$ bestimmt wird, und die Induktivität $L$ der Löschspule entsprechend der Resonanzbeziehung ermittelt und verstellt wird, sodass die gewünschte kompensierte, unterkompensierte oder überkompensierte Abstimmung des Netzes erreicht wird.

Alternativ dazu kann mit einer Regeleinheit die Induktivität der Löschspule so lange verstellt werden, bis die gewünschte kompensierte, unterkompensierte oder überkompensierte Abstimmung der Löschspule erreicht wird.

Eine weiteres vorteilhaftes Ergebnis des erfindungsgemäßen Verfahrens ist es, dass aus den ermittelten Netzparametern spezifische Kenngrößen, wie beispielsweise der Spulenstrom $i_{Lres}$, also dem Löschspulenstrom in Resonanz bei Netzfrequenz und Sternpunkt-Verlagerungsspannung $U_{ne}$ gleich der Phasennennspannung, oder der

Wattreststrom $i_W$ des Netzes, berechnet und angezeigt werden. Solche Kenngrößen dienen dem Fachmann zur Beurteilung des Gesamtzustandes des Netzes und sind im Zusammenhang mit dem Isolationszustand wichtige Hinweise auf die Qualität des Netzes.

Eine sehr günstiges ausführbares Verfahren erhält man, wenn die Hilfssignale bezüglich aller eingespeisten Frequenzen $\omega_i$ und $\omega_N$ durch einen Signalgenerator erzeugt werden. Dies lässt sich einfach durchführen, indem die Hilfssignale durch eine Tiefpassfilterung eines Rechtecksignals, welches durch Überlagerung von Rechtecksignalen der einzelnen Frequenzen aller Frequenzanteile $\omega_i$ und $\omega_N$ gebildet wird, erzeugt werden. In sehr einfacher Weise wird das Rechtecksignal im Signalgenerator durch das Öffnen und Schließen von Schaltern S1, S2, S3 und S4, vorzugsweise Transistoren, in den Zweigen einer H-Brücke durch eine Ansteuereinheit erzeugt und das Rechtecksignal in der Diagonale der H-Brücke abgegriffen. Die Tiefpassfilterung des Rechtecksignals erfolgt bei Bedarf am einfachsten in einem aus einer Induktivität $L_C$ und eventuell einer Kapazität $C_C$ bestehendem Tiefpassfilter, das so dimensioniert wird, dass aus dem in der H-Brücke erzeugten Rechtecksignal alle Frequenzanteile größer einer vordefinierten Eckfrequenz aus dem einzuspeisenden Hilfssignal herausgefiltert werden.

Auf diese Weise kann das Summensignal des einzuspeisenden Hilfssignales durch weitgehend entkoppelte Überlagerung der einzelnen Signalanteile mit unterschiedlicher Grundwellenfrequenz in Betrag und Phase erzeugt werden.

Zur Sicherheit der Vorrichtung ist es günstig, wenn ein Überspannungsschutz vorgesehen ist, mit dem die Leistungshilfswicklung der Löschspule im Falle eines Erdfehlers und/oder wenn der Verlagerungsstrom $i_{vS}(\omega_N)$ einen maximal zulässigen Wert überschreitet, durch einen Schalter S5 von der Schaltung zur Generierung der Hilfssignale abtrennbar ist.

Eine ganz besonders flexible, günstige und einfache Ausführungsform erhält man, wenn als Regeleinheit und/oder Ansteuereinheit ein Mikrocomputer vorgesehen ist.

Die Erfindung wird anhand der folgenden Erläuterungen unter Bezugnahme auf die begleitenden beispielhaften und schematischen Zeichnungen Fig. 1 bis Fig. 3 näher beschrieben. In den Zeichnungen zeigt

    Fig. 1 das elektrische Ersatzschaltbild des Nullsystems und eines Abzweiges eines sternpunktkompensierten Netzes,

    Fig. 2 ein beispielhaftes, schematisches Schaltbild zur Erzeugung der Hilfssignale und zur Auswertung des Netzzustandes,

    Fig. 3 ein zwei unterschiedliche Frequenzen, $\omega$ und $\frac{\omega}{2}$, enthaltendes, überlagertes Rechtecksignal.

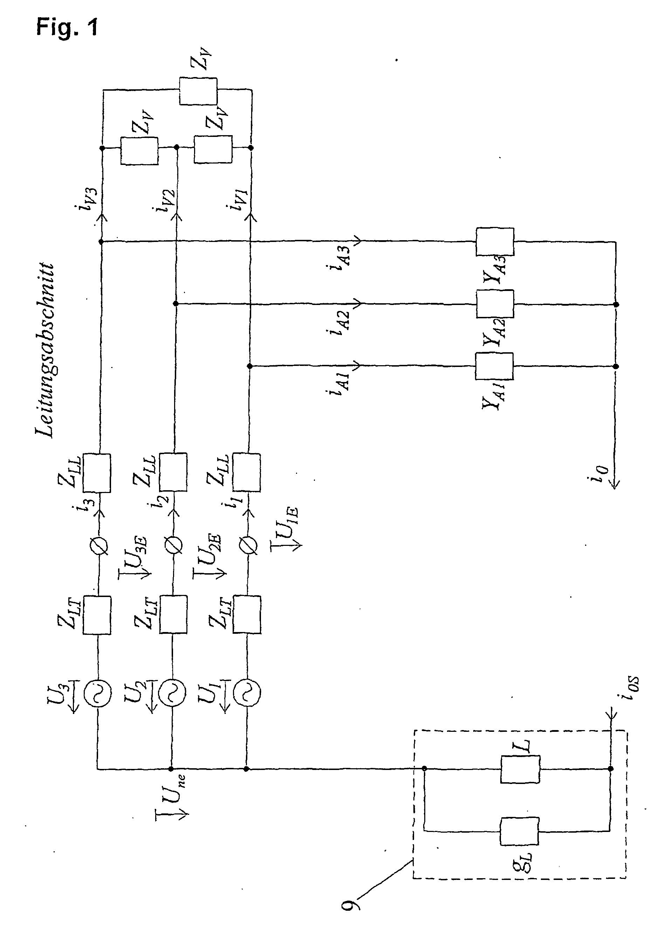

In Fig. 1 ist das bekannte elektrische Ersatzschaltbild eines Leitungsabschnittes eines Hochspannungsnetzes dargestellt. Zwischen dem Transformatorsternpunkt und dem Erdungspunkt befindet sich eine Löschspule 9, die durch einen ohmschen Leitwert $g_L$ und einer Induktivität $L$ beschrieben wird. Die Streuinduktivitäten sowie die ohmschen Widerstände der Sekundärwicklung des Speisetransformators werden durch die für alle drei Phasen als gleich groß angenommenen Leitungslängsimpedanzen $Z_{LT}$ repräsentiert. In das Netz, hier bestehend aus nur einem Leitungsabschnitt, werden die Phasenspannungen $U_1$, $U_2$ und $U_3$ eingespeist und es fließen die Phasenströme $i_1$, $i_2$ und $i_3$. Zwischen den drei Phasen und der Erde liegen die Phasen-Erdspannungen $U_{1E}$, $U_{2E}$ und $U_{3E}$ an.

Ein Leitungsabschnitt wird, wie für den betrachteten Frequenzbereich von <100Hz zulässig, durch Leitungslängsimpedanzen $Z_{LL}$, bestehend aus einem ohmschen und einem induktiven Term, und Leitungsableitadmittanzen $Y_{A1}$, $Y_{A2}$ und $Y_{A3}$, bestehend aus einem ohmschen und einem kapazitiven Term, beschrieben. Über die Leitungsableitadmittanzen $Y_{A1}$, $Y_{A2}$ und $Y_{A3}$ fließen die Ableitströme $i_{A1}$, $i_{A2}$ und $i_{A3}$. Die Ableitströme $i_{A1}$, $i_{A2}$ und $i_{A3}$ fließen als Nullstrom $i_0$ dieses Leitungsabschnittes über die Löschspule 9 zum Transformatorstempunkt zurück. Am Erdungspunkt der Löschspule 9 vereinigen sich die Nullströme aller vorhanden Leitungsabschnitte zur Summe der Nullströme $i_{0S}$. Verbraucherseitig, repräsentiert durch Verbraucherimpedanzen $Z_v$, fließen die Verbraucherströme $i_{v1}$, $i_{v2}$ und $i_{v3}$.

Dieses Ersatzschaltbild wird zur Herleitung von für das erfindungsgemäße Verfahren wichtigen Beziehungen verwendet.

Zu den folgenden Erläuterungen sei vorab angemerkt, dass sich die nachfolgenden Formeln, wenn nicht anders angemerkt, auf die Laplacetransformierten der jeweiligen elektrischen Größen beziehen, die vorkommenden elektrischen Größen zwecks Vereinfachung der Schreibweise jedoch nicht explizit als Funktion der komplexen Frequenzvariablen $s$ geschrieben werden, also wird beispielsweise $U_{ne}(s)$ mit $U_{ne}$ bezeichnet.

Wie aus dem elektrischen Ersatzschaltbild Fig. 1 entnommen werden kann, ergibt sich der Nullstrom $i_0$ eines beliebigen Abzweiges als sehr gute Näherung aus der Beziehung

$$i_0 = U_{ne} \cdot Y + i_v,$$

mit der Erdadmittanz $Y = (Y_{A1} + Y_{A2} + Y_{A3})$ und dem Verlagerungsstrom, bzw. Unsymmetriestrom, $i_v = (U_1 \cdot \Delta Y_{A1} + U_2 \cdot \Delta Y_{A2} + U_3 \cdot \Delta Y_{A3})$, wobei die $\Delta Y_{Ai}$ die Unsymmetrie der Erdadmittanzen beschreiben.

Für die Erdadmittanz $Y$ eines Abzweiges $k$ genügt es im betrachteten Frequenzbereich (<100Hz) in hinreichender Genauigkeit $Y$ durch die Summe der einzelnen Phasen-Erdkapazitäten $C$ parallel zu der Summe der ohmschen Leitwerte der drei Phasen gegen Erde $g$ zu repräsentieren.

$$Y^{(k)} = g^{(k)} + C^{(k)}{}_{s}$$

Für die Summe der Nullströme aller Abzweige $i_{0S}$ gilt dann für das erdfehlerfreie Gesamtnetz

$$i_{0S} = U_{ne} \cdot Y_S + i_{vS},$$

wobei $Y_S$ die Summe der Erdadmittanzen aller Abzweige und $i_{vS}$ die Summe der Verlagerungsströme aller Abzweige oder Leitungsabschnitte bezeichnet. Gemäß der Beziehung für die Erdadmittanz $Y$ eines Abzweiges folgt durch Summenbildung, mit dem Summenfeitwert $g_s$ aller Abzweige und der Summenkapazität $C_S$ aller Abzweige

$$Y_S = g_S + C_S s.$$

Die Nullströme aller Abzweige $i_{0S}$ fließen dabei über die Löschspule zum Transformatorstempunkt zurück, wodurch folgende Beziehung aufgestellt werden kann.

$$i_{0S} = -U_{ne} \cdot Y_L$$

$Y_L$ *ist* die Admittanz vom Erdungspunkt der Löschspule bis zum Transformatorsternpunkt und setzt sich aus einem Leitwert $g_L$ und der Induktivität $L$ zusammen.

$$Y_L = g_L + \frac{1}{L \cdot s}$$

Durch Gleichsetzen der obigen Gleichungen für den Summennullstrom $i_{0S}$ erhält man eine Beziehung zwischen der Verlagerungsstromsumme $i_{vS}$ und der Sternpunkt-Verlagerungsspannung $U_{ne}$.

$$i_{vS} = -U_{ne} \cdot (Y_S + Y_L)$$

Ersetzt man in der obigen Beziehung jetzt die komplexe Frequenzvariable $s$ durch $j\omega$, mit der Kreisfrequenz $\omega_N = 2\pi f_N$ und der Netzfrequenz $f_N$, ergibt sich die folgende Gleichung

$$i_{vS}(\omega_N) = -U_{ne}(\omega_N) \cdot [Y_S(\omega_N) + Y_L(\omega_N)],$$

mit $Y_S(\omega_N) = g_s + j\omega_N C_s$ und $Y_L(\omega_N) = g_L + \frac{1}{j\omega_N L}$.

Durch aktives Einbringen eines Stromes $i_{vC}(\omega)$ in den Stempunkt, beispielsweise durch Stromeinspeisung in die Leistungshilfswicktung der Löschspule, folgt aus dem Überlagerungssatz direkt

$$[i_{vS}(\omega_N)+i_{vC}(\omega_N)] = -U_{ne}(\omega_N) \cdot [Y_s(\omega_N)+Y_L(\omega_N)].$$

Aus dieser Gleichung erhält man die wichtige Erkenntnis, dass die Sternpunkt-Verlagerungsspannung $U_{ne}(\omega_N)$ Null sein muss, wenn man den einzuspeisenden Strom $i_{vC}(\omega_N)$ nach der Beziehung

$$[i_{vS}(\omega_N)+i_{vC}(\omega_N)] = 0 \Rightarrow i_{vC}(\omega_N) = -i_{vS}(\omega_N)$$

wählt, da der Term $[Y_S(\omega_N)+Y_L(\omega_N)]$ nur Netzgrößen enthält und sicherlich ungleich Null ist. Das bedeutet, dass die Sternpunkt-Verlagerungsspannung $U_{ne}(\omega_N)$ kompensiert wird, wenn der eingespeiste Strom $i_{vC}(\omega_N)$ so geregelt wird, dass er dem negativen Verfagerungsstrom $i_{vS}(\omega_N)$ folgt.

Dadurch, dass die Sternpunkt-Verlagerungsspannung $U_{ne}(\omega_N)$ bei Netzfrequenz zu Null geregelt wird, können durch Messung der Nullströme $i_0^{(k)}$ der einzelnen Abzweige oder Leitungsabschnitte $k$ des Netzes direkt die natürlichen Verlagerungsströme $i_{0\,v}^{(k)}$ einschließlich eines eventuell vorhandenen Fehlerstromes dieser Abzweige oder Leitungsabschnitte gemessen werden, da die durch die Erdadmittanzen verursachten Nulistromanteile des Abzweiges oder Leitungsabschnittes wegen des Fehlens einer Sternpunkt-Verlagerungsspannung nicht vorhanden sind. Diese gemessenen Nullströme $i_0^{(k)}$ können dann einer beliebigen Methode zur Ortung von Erdfehlern zugeführt werden.

Im folgenden wird beispielhaft eine Möglichkeit zur Ortung von Erdfehlern beschrieben. Im Falle eines einpoligen Erdfehlers irgendwo im Netz steigt die Verlagerungsstromsumme $i_{vS}(\omega_N)$ plötzlich stark an. Dieser Anstieg kann sehr einfach durch Überwachung des einzuspeisenden Stromes $i_{vC}(\omega_N)$ detektiert werden, da die Regelbedingung $i_{vC}(\omega_N) = -i_{vS}(\omega_N)$ gilt und somit zwangsweise gleichzeitig auch der einzuspeisende Strom $i_{vC}(\omega_N)$ ansteigt. Überschreitet der Betrag des einzuspeisenden Stromes $i_{vC}(\omega_N)$ eine bestimmte vordefinierte Fehlerschwelle für eine vordefinierte Zeit, wird ein Erdfehler erkannt und angezeigt. Alternativ dazu kann zur Erkennung eines Erdfehlers auch die zeitliche Änderung des einzuspeisenden Stromes $i_{vC}(\omega_N)$ in Form des Betrages einer komplexen Stromdifferenz, auf eine Überschreitung einer Fehlerschwelle überwacht werden. Der defekte Abzweig oder Leitungsabschnitt kann durch Messung des Netzfrequenzanteiles des Nullstromes $i_0^{(k)}$ in Betrag und Phase , der bei einer zu Null geregelten Sternpunkt-Verlagerungsspannung $U_{ne}(\omega_N)$ der Summe aus dem natürlichen Verlagerungsstrom $i_0^{(k)}$ und eines eventuell vorhandenen Fehlerstromes dieses Abzweiges oder Leitungsabschnittes entspricht, geortet werden. Eine einfache Methode ist, die Beträge, Effektivwerte oder Amplituden der Nullströme $i_0^{(k)}$ bei Netzfrequenz aller zu überwachender Abzweige oder Leitungsabschnitte $k$ auf eine eventuelle Überschreitung einer vordefinierten Fehlerschwelle für eine vordefinierte Zeit zu überwachen. Eine andere Methode ist, die Beträge bzw. die Effektivwerte der zeitlichen Änderung der Nullströme bei Netzfrequenz aller zu überwachender Abzweige oder Leitungsabschnitte $k$, also die Beträge von komplex berechneten Nullstromdifferenzen, auf eine Überschreitung einer Fehlerschwelle zu überwachen. Allerdings ist auch jede andere beliebige bekannte Methode zur Ortung des defekten Abzweiges oder Leitungsabschnittes und/oder der defekten Stelle innerhalb des defekten Abzweiges oder Leitung möglich.

Dieses Verfahren ist natürlich nur solange anwendbar, solange der Signalgenerator in der Lage ist, die netzfrequente Sternpunkt-Verlagerungsspannung, durch Einspeisen eines entsprechenden Stromes auf Null zu regeln. Wird diese Grenze überschritten ist es sinnvoll auf eine anderes Verfahren zur Ortung von Erdfehlern umzuschalten, bis der einzuspeisende Strom vom Signalgenerator wieder aufgebracht werden kann.

Um auch bei kompensierter Sternpunkt-Verlagerungsspannung die Abstimmung der Löschspule durchtühren zu können, wird mindestens ein weiterer Strom $i_{vC}(\omega_i)$, mit $\omega_i \neq \omega_N$, in den Sternpunkt eingespeist und es ergibt sich unter der Voraussetzung, dass sich die Frequenzspektren der einzelnen Frequenzen nicht decken bzw. überlagern und damit keine natürlichen Verlagerungsströme des Netzes bei dieser Frequenz $(\omega_i) \neq \omega_N$ vorhanden sind, $i_{vS}(\omega_i) = 0$, äquivalent zu oben die Gleichung

$$i_{vC}(\omega_i) = U_{ne}(\omega_i)\cdot[Y_S(\omega_i)+Y_L(\omega_i)],$$

mit $Y_s(\omega_i) = g_s + j\omega_i C_S$ und $Y_L(\omega_i) = g_L + \frac{1}{j\omega_i L}$, woraus sich wegen der Bekanntheit der Löschspuleninduktivität $L$ aus der aktuellen Stellung der Löschspule durch Einsetzen von $L$ in die obigen Gleichungen die Leitwertsumme $(g_S + g_L)$ und die Summenkapazität $C_S$ des Netzes, also die gewünschten Netzparameter, ermitteln lassen.

$$-\frac{i_{vC}(\omega_i)}{U_{ne}(\omega_i)} = [Y_S(\omega_i)+Y_L(\omega_i)] = (g_s + g_L) + j\left(\omega_i C_S - \frac{1}{\omega_i L}\right)$$

Daraus folgt direkt

$$(g_s+g_L) = \mathrm{Re}[Y_S(\omega_i)+Y_L(\omega_i)]$$

und

$$C_S = \frac{1}{\omega_i}\left\{\mathrm{Im}[Y_S(\omega_i)+Y_L(\omega_i)]+\frac{1}{\omega_i L}\right\}.$$

Durch kontinuierliches Messen des eingespeisten Stromes $i_{vC}(\omega_i)$ in Betrag und Phase bei Kreisfrequenz $\omega_i$ und der sich dabei ergebenden Sternpunkt-Verlagerungsspannung $U_{ne}(\omega_i)$ bei einer Frequenz ungleich der Netzfrequenz, $\omega_i \neq \omega_N$, nach Betrag und Phase können also aus den obigen Gleichungen die Netzparameter direkt kontinuierlich berechnet werden. Diese Netzparameter können auch für mehrere verschiedene Frequenzen $\omega_i \neq \omega_N$ ermittelt werden und anschließend aus den einzelnen Größen ein Mittelwert im Sinne der bestmöglichen Approximation der realen Größen bestimmt werden.

Die Resonanzabstimmung der Löschspule erfolgt dann bei Netzfrequenz $\omega_N$ anhand der bekannten Resonanzbedingung

$$\mathrm{Im}[Y_S(\omega_N)+Y_L(\omega_N)]=0 \Rightarrow \omega_N C_s = \frac{1}{\omega_N L}$$

Aus dieser Gleichung kann die erforderliche Löschspuleninduktivität $L$ zum Erreichen der der gewünschten kompensierten, über- oder unterkompensierten Abstimmung ermittelt werden, worauf die Löschspule direkt abgestimmt werden kann.

Das oben beschriebene Verfahren zur Abstimmung der Löschspule ist nicht einschränkend, es sind vielmehr auch alle anderen möglichen Verfahren sowie Kombinationen bestimmter Verfahren anwendbar. Z.B. ist es denkbar, die Induktivität der Löschspule in einem Regelkreis solange zu verändern, bis der Resonanzpunkt erreicht ist oder sich eine entsprechende über- oder unterkompensierte Stellung ergibt.

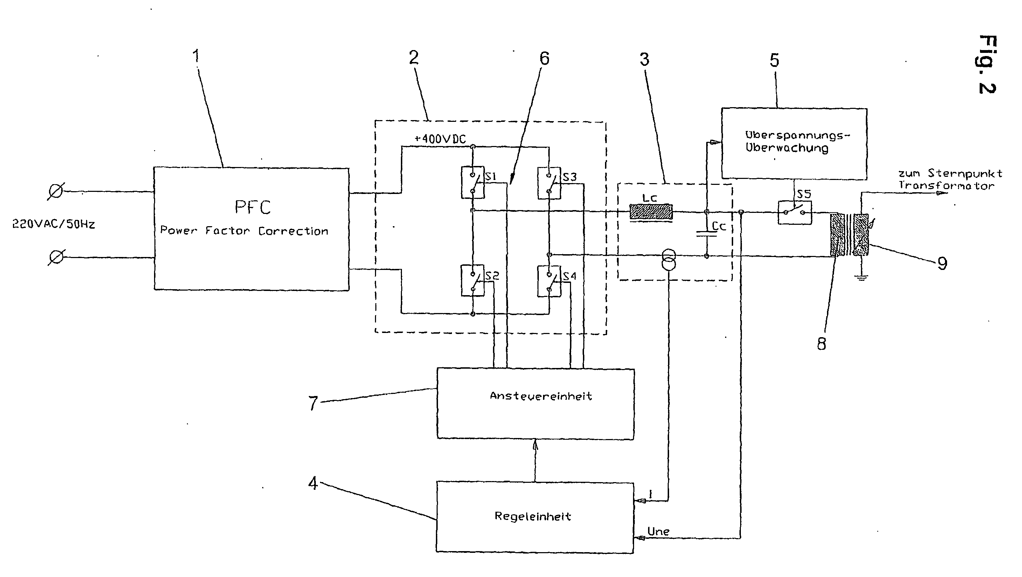

Die Generierung der einzuspeisenden Hilfssignale und die Auswertung der gemessenen Größen wird beispielhaft anhand der Fig. 2 beschrieben. Die Schaltung zur Generierung der Hilfssignale enthält eine Gleichrichtereinheit 1, einen Signalgenerator 2 mit einem nachgeschalteten Tiefpassfilter 3, eine Regeleinheit sowie einen Überspannungsschutz 5. Die Gleichrichtereinheit 1 beinhaltet neben einem Netztrenntransformator, der Vollwegleichrichtung und den Glättungskondensatoren eine Power Factor Correction (PFC) Schaltung und verwendet als Speisespannung beispielsweise die konventionelle Netzspannung, also 230V, 50Hz. Die PFC Schaltung gewährleistet, dass von der Netzversorgung nur reine Wirkleistung aufgenommen wird, wodurch sich eine sehr geringe Leistungsaufnahme des Gesamtsystems ergibt, und bietet am Ausgang zur weiteren Verwendung eine Gleichspannung von 400V an. Je nach Ausführung der PFC Schaltung und nach Bedarf kann auch eine andere DC Spannung geliefert werden. Die PFC Schaltung speist einen Signalgenerator 2, der eine H-Brücke 6 enthält, in deren Zweigen je ein Schalter S1, S2, S3 und S4, vorzugsweise Transistoren, angeordnet ist. Die Schalter S1, S2, S3 und S4 können über eine Ansteuereinheit 7 unabhängig voneinander geschlossen oder geöffnet werden. An der Diagonale der H-Brücke 6 wird ein Signal abgegriffen, welches in einem nachgeschaltenen aus einer Induktivität $L_C$ und einer Kapazität $C_C$ bestehenden Tiefpassfilter 3 gefiltert wird. Das gefilterte Signal wird in diesem Beispiel über eine Leistungshilfswicklung 8 der Löschspule 9 in den Sternpunkt des Transformators eingespeist. Sollten die Oberwellen des einzuspeisenden Signals nicht stören, so kann die Kapazität $C_C$ auch entfallen, da alleine schon durch das integrale Stromverhalten der Induktivität $L_C$ aus Spannungsrechtecken Stromtrapeze geformt werden und dadurch der Oberwellenanteil des einzuspeisenden Stromes schon deutlich reduziert ist.

Als Regelgrößen werden die Sternpunkt-Verlagerungsspannung $U_{ne}$ und der eingespeiste Strom $i_{vC}$ kontinuierlich nach Betrag und Phase, für alle interessanten Frequenzen, gemessen und einer Regeleinheit 4 zugeführt, die wiederum die Ansteuersignale für die Ansteuereinheit 7 bereitstellt.

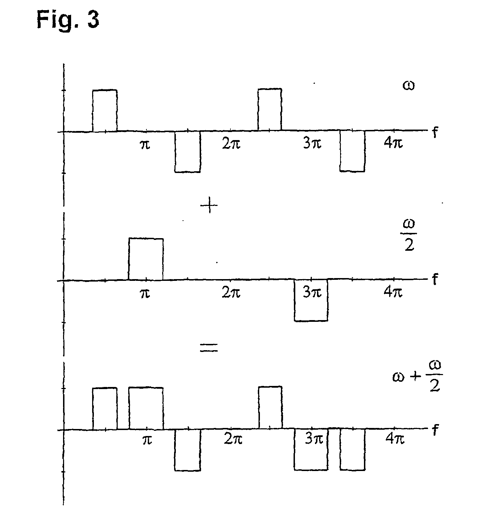

Die Ansteuereinheit 7 steuert die Schalter S1, S2, S3 und S4 so an, dass an der Diagonalen der H-Brücke 6 ein aus mehreren einzelnen Rechtecksignalen bestehendes überlagertes Rechtecksignal entsteht, welches alle einzuspeisenden Frequenzen beinhaltet. Ein positives Ausgangssignal von 400VDC wird erzeugt, wenn die Schalter S1 und S4 durchgesteuert werden und die Schalter S2 und S3 offen bleiben. Umgekehrt entsteht an der Brückendiagonale ein Ausgangssignal von -400VDC, wenn die Schalter S2 und S3 durchgesteuert werden und die Schalter S1 und S4 offen bleiben. Soll eine Ausgangsspannung von 0VDC realisiert werden, so werden die Schalter S2 und S4 durchgesteuert und die beiden restlichen Schalter offengelassen. Soll unabhängig von der Sternpunkt-Verlagerungsspannung kein Brückendiagonalstrom fließen, so sind alle Schalter S1, S2, S3 und S4 zu öffnen. Ein solches Rechtecksignal, das die Netzfrequenz von 50Hz und eine weitere Frequenz von 25Hz beinhaltet ist in Fig. 3 dargestellt. Insbesondere müssen bei dem erfindungsgemäßen Verfahren zumindest die Netzfrequenz $\omega_N$ und eine weitere Frequenz $\omega_i$ beinhaltet sein, wobei alle Frequenzen $\omega_i \neq \omega_N$ sinnvollerweise so gewählt werden, dass sich die Grundwellenanteile als auch die Oberwellenanteile der einzelnen Frequenzspektren nicht überschneiden. Damit wird sichergestellt, dass die einzelnen Frequenzanteile unabhängig voneinander betrachtet werden dürfen und kein Hilfssignal Anteile einer anderen Frequenz enthält. Günstig sind beispielsweise die Frequenzen $\omega_i = \frac{\omega_N}{2}$ oder $\omega_i = \frac{3\omega_N}{2}$. Das so erzeugte Rechtecksignal wird im Anschluss einem Tiefpassfilter 3 zugeführt, das so dimensioniert ist, dass bei Bedarf höhere Frequenzanteile herausgefiltert werden, wodurch gemäß der Fourierreihenzerlegung von dem Rechtecksignal nur mehr die niederfrequenten Anteile der einzelnen einzuspeisenden Frequenzen übrigbleiben, deren Amplituden über die Pulsdauer $T_E$ der einzelnen Rechtecksignale einzeln steuerbar sind und deren gemeinsame Phasenbeziehung ebenfalls steuerbar ist. Es ist sinnvoll die Amplituden der eingespeisten Ströme der Frequenzen $\omega_i \neq \omega_N$ derart zu wählen, dass die im Netz daraus resultierenden Verlagerungsspannungen die Größenordnungen von ungefähr 1% der Grundwelle der Phasenspannung annehmen, also bezogen auf die Phasenspannung des Netzes klein und damit als nicht netzfrequente Überlagerungen vernachlässigbar werden. Die Amplitude des Signals mit der Netzfrequenz $\omega_N$ und die gemeinsame Phasenbeziehung der Signale, werden durch die Regeleinheit aufgrund der vorher angegebenen Regelbedingung, $i_{vC}(\omega_N) = -i_{vS}(\omega_N)$, entsprechend geregelt.

Zum Schutz der einzelnen Komponenten bei Erdschlüssen ist weiters ein Überspannungsschutz 5 vorgesehen, der die Leistungshilfswicklung 8 bei Bedarf über den Schalter S5 von der Schaltung zur Hilfssignalgenerierung trennt.

In der Regeleinheit 4 werden die gemessenen Größen gemäß dem oben beschriebenen Verfahren zur Abstimmung der Löschspule 9 und/oder zur Detektierung von Erdfehlern ausgewertet.

Die oben beschriebene Schaltung ist nur ein Beispiel wie die einzuspeisenden Hilfssignale erzeugt werden können und ist in keiner Weise einschränkend. Es ist insbesondere auch denkbar für jedes Hilfssignal einen eigenen Signalgenerator, der ein entsprechendes Signal generiert, zu verwenden. Ferner besteht die Möglichkeit die Hilfssignale in Form einer galvanisch getrennten Spannungsquelle in Serienschaltung zur Löschspule, über eine galvanische Trennung in Form einer Strominjektion in eine von den drei Phasen-Erdspannungen oder in jeder anderen geeigneten Art und Weise in das Nullsystem einzubringen.

**Patentansprüche**

**1.** Verfahren zur selektiven Erkennung und Ortung von hochohmigen einpoligen Erdfehlern in sternpunktkompensierten elektrischen Versorgungsnetzen, bei dem in das Nullsystem des Netzes zumindest ein Hilfssignal mit der Netzfrequenz $\omega_N$ eingespeist wird, **dadurch gekennzeichnet, dass** das Hilfssignal so eingespeist wird, dass **dadurch** die Sternpunkt-Verlagerungsspannung $U_{ne}(\omega_N)$ bei Netzfrequenz $\omega_N$ im Wesentlichen kompensiert wird und dass Erdfehler bei durch das Hilfssignal kompensierter Sternpunkt-Verlagerungsspannung $U_{ne}(\omega_N)$ erkannt

und geortet werden.

2. Verfahren nach Anspruch 1, **dadurch gekennzeichnet, dass** das Hilfssignal kontinuierlich eingespeist wird.

3. Verfahren nach Anspruch 1 oder 2, **dadurch gekennzeichnet, dass** das in Form eines Stromes eingespeiste Hilfssignal bei Netzfrequenz $i_{vC}(\omega_N)$ durch eine Regeleinheit (4) in Betrag und Phase so gesteuert wird, dass die Summe aus diesem eingespeisten Hilfssignal $i_{vC}(\omega_N)$ und dem natürlichen Verlagerungsstrom $i_{vS}(\omega_N)$ im Wesentlichen gleich Null wird und **dadurch** die Sternpunkt-Verlagerungsspannung $U_{ne}(\omega_N)$ kompensiert wird.

4. Verfahren nach Anspruch 3, **dadurch gekennzeichnet, dass** durch Messen des eingespeisten Stromes bei Netzfrequenz $i_{vC}(\omega_N)$ im eingeregelten Zustand, $i_{vC}(\omega_N)+i_{vS}(\omega_N) = 0$, indirekt der Verlagerungsstrom $i_{vS}(\omega_N)$ gemessen wird und dass mit diesem gemessenen Strom $i_{vC}(\omega_N)$ ein Erdfehler im Gesamtnetz erkannt wird.

5. Verfahren nach Anspruch 4, **dadurch gekennzeichnet, dass** ein Erdfehler erkannt und angezeigt wird, wenn der Messwert des einzuspeisenden Stromes bei Netzfrequenz $i_{vC}(\omega_N)$, vorzugsweise die Amplitude, der Betrag oder der Effektivwert, stark ansteigt und eine vordefinierte Fehlerschwelle für eine vordefinierte Zeit überschreitet.

6. Verfahren nach Anspruch 4, **dadurch gekennzeichnet, dass** ein Erdfehler erkannt und angezeigt wird, wenn der Betrag der komplexen Differenz zweier zeitlich aufeinanderfolgender Messungen des einzuspeisenden Stromes bei Netzfrequenz $i_{vC}(\omega_N)$ stark ansteigt und eine vordefinierte Fehlerschwelle überschreitet.

7. Verfahren nach Anspruch 5 oder 6, **dadurch gekennzeichnet, dass** durch Messen des Nullstromes $i_0^{(k)}(\omega_N)$ im eingeregelten Zustand, also bei $U_{ne}(\omega_N) = 0$, von jedem Abzweig oder Leitungsabschnitt $k$ des Netzes bei Netzfrequenz $\omega_N$ direkt die Summe aus dem natürlichen Verlagerungsstrom $i_v^{(k)}(\omega_N)$ und einem eventuell vorhandenen Fehlerstrom des jeweiligen $k$ - $ten$ Abzweiges oder Leitungsabschnittes bei Netzfrequenz gemessen wird und dass diese Nullströme $i_0^{(k)}(\omega_N)$ zur Ortung des fehlerhaften Abzweiges oder Leitungsabschnittes des Netzes und/oder der fehlerhaften Stelle innerhalb dieses Abzweiges oder Leitungsabschnittes herangezogen werden.

8. Verfahren nach Anspruch 7, **dadurch gekennzeichnet, dass** für einen Abzweig oder Leitungsabschnitt $f$ der zugehörige Nullstrom $i_0^{(k)}(\omega_N)$, vorzugsweise die Amplitude, der Betrag oder der Effektivwert, mit einer vordefinierten Fehlerschwelle verglichen und als fehlerhaft erkannt und angezeigt wird, wenn der Betrag des komplexen Nullstromvektors $i_0^{(k)}(\omega_N)$ diese Fehlerschwelle für eine vordefinierte Zeit überschreitet.

9. Verfahren nach Anspruch 7, **dadurch gekennzeichnet, dass** für einen Abzweig oder Leitungsabschnitt $f$ von zwei zeitlich aufeinanderfolgenden Messungen des zugehörigen Nullstromes $i_0^{(k)}(\omega_N)$ die komplexe Differenz gebildet, der Betrag dieser Differenz mit einer vordefinierten Fehlerschwelle verglichen und ein fehlerhafter Abzweig oder Leitungsabschnitt erkannt und angezeigt wird, wenn der Betrag der Differenz diese Fehlerschwelle überschreitet.

10. Verfahren nach Anspruch 8 oder 9, **dadurch gekennzeichnet, dass** bei Überschreiten einer vorbestimmten Größe des einzuspeisenden Stromes $i_{vC}(\omega_N)$ auf ein anderes geeignetes Verfahren zur Erkennung und/oder Ortung von Erdfehtern umgeschalten wird.

11. Verfahren nach einem der Ansprüche 1 bis 10, **dadurch gekennzeichnet, dass** zumindest ein weiteres Hilfssignal mit einer Frequenz $\omega_i$ ungleich der Netzfrequenz $\omega_N$ eingespeist wird und dass dieses Hilfssignal zur Abstimmung einer Löschspule (9) des Netzes bei Netzfrequenz $\omega_N$ verwendet wird.

12. Verfahren nach Anspruch 11, **dadurch gekennzeichnet, dass** das in Form eines elektrischen Stromes eingespeiste weitere Hilfssignal $i_{vC}(\omega_1)$ und die daraus entstehende Sternpunkt-Verlagerungsspannung $U_{ne}(\omega_1)$ bezüglich einer Frequenz $\omega_1$, ungleich der Netzfrequenz $\omega_N$, beispielsweise $\omega_1 = \frac{\omega_N}{2}$ oder $\omega_1 = \frac{3\omega_N}{2}$, kontinuierlich nach Betrag und Phase gemessen werden, und dass durch Quotientenbildung von $i_{vC}(\omega_1)$ und $U_{ne}(\omega_1)$ die Admittanzsumme, aus der Erdadmittanz aller Abzweige oder Leitungsabschnitte des Netzes $Y_S(\omega_1)$ und der Löschspulen-

admittanz $Y_L(\omega_1)$, aus der Beziehung

$$- \frac{i_{vC}(\omega_1)}{U_{ne}(\omega_1)} = [Y_S(\omega_1) + Y_L(\omega_1)]$$

bestimmt wird.

13. Verfahren nach Anspruch 12, **dadurch gekennzeichnet, dass** durch Aufspaltung der Beziehung

$$\left[Y_S(\omega_1) + Y_L(\omega_1)\right] = (g_S + g_L) + j\left(\omega_1 C_S - \frac{1}{\omega_1 L}\right)$$

in Real- und Imaginärteil und aufgrund der bekannten Induktivität L der Löschspule (9) aus der Gleichung

$$C_S = \frac{1}{\omega_1} \cdot \left\{ \text{Im}[Y_S(\omega_1) + Y_L(\omega_1)] + \frac{1}{\omega_1 L} \right\}$$

die Summenkapazität $C_S$ des Gesamtnetzes und/oder aus der Gleichung

$$(g_S + g_L) = \text{Re}[Y_S(\omega_1) + Y_L(\omega_1)]$$

die Leitwertsumme aus dem Summenleitwert $g_S$ des Gesamtnetzes und dem Spulenleitwert $g_L$ der Löschspule (9) bestimmt wird.

14. Verfahren nach den Ansprüchen 12 und 13, **dadurch gekennzeichnet, dass** mehrere Ströme $i_{vC}(\omega_i)$ mit bezüglich der Netzfrequenz $\omega_N$ und untereinander unterschiedlicher Frequenzen $\omega_i$ eingespeist werden, dass die notwendigen Netzparameter, insbesondere $[Y_S(\omega_i) + Y_L(\omega_i)]$, $C_S$ und $(g_S + g_L)$, für jede einzelne Frequenz $\omega_i$ bestimmt werden und dass aus den Messwerten jeder einzelnen Frequenz $\omega_i$ mit einer beliebigen Methode eine bestmögliche Approximation der Netzparameter ermittelt wird.

15. Verfahren nach einem der Ansprüche 11 bis 14, **dadurch gekennzeichnet, dass** die Größen der eingespeisten Ströme $i_{vC}(\omega_i)$ mit einer Frequenz $\omega_i$ ungleich der Netzfrequenz $\omega_N$ so gewählt werden, dass die Effektivwerte der daraus resultierenden Sternpunkt-Verlagerungsspannungen $U_{ne}(\omega_i)$ bei den jeweiligen Frequenzen $\omega_i$ vergleichsweise klein, vorzugsweise kleiner 10% des Effektivwertes der Grundwelle der Phasennennspannung des Netzes, werden.

16. Verfahren nach einem der Ansprüche 11 bis 15, **dadurch gekennzeichnet, dass** die Frequenzen $\omega_i$ so gewählt werden, dass sich die Grundwellenanteile sowie die Oberwellenanteile der Frequenzspektren aller eingespeisten Signale mit den Grundwellenfrequenzen $\omega_i$ und $\omega_N$ nicht überschneiden.

17. Verfahren nach Anspruch 12, 13 oder 14, **dadurch gekennzeichnet, dass** mit den ermittelten Netzparametern die Löschspule (9) für das Netz bei Netzfrequenz $\omega_N$ abgestimmt wird.

18. Verfahren nach Anspruch 17, **dadurch gekennzeichnet, dass** mit der Summenkapazität $C_S$ des Gesamtnetzes der Resonanzpunkt bei Netzfrequenz $\omega_N$ nach der bekannten Resonanzbeziehung

$$\text{Im}[Y_S(\omega_N) + Y_L(\omega_N)] = 0 \Rightarrow \omega_N C_S = \frac{1}{\omega_N L}$$

bestimmt wird, und dass die Induktivität $L$ der Löschspule (9) entsprechend der Resonanzbeziehung ermittelt und verstellt wird, sodass die gewünschte kompensierte, unterkompensierte oder überkompensierte Abstimmung der Löschspule (9) erreicht wird.

19. Verfahren nach Anspruch 17, **dadurch gekennzeichnet, dass** eine Regeleinheit (4) die induktivität der Löschspule (9) mit einem eigenen Regelkreis so lange versteilt, bis die gewünschte kompensierte, unterkompensierte oder überkompensierte Abstimmung der Löschspule (9) erreicht wird.

20. Verfahren nach einem der Ansprüche 12, 13 oder 14, **dadurch gekennzeichnet, dass** aus den ermittelten Netzparametern spezifische Kenngrößen, wie beispielsweise der Spulenstrom $i_{Lres}$, also der Löschspulenstrom in Resonanz bei Netzfrequenz und Sternpunkt-Verlagerungsspannung $U_{ne}$ gleich der Phasennennspannung, oder der Wattreststrom $i_w$ des Netzes, berechnet und angezeigt werden.

21. Verfahren nach einem der Ansprüche 1 bis 20, **dadurch gekennzeichnet, dass** die Hilfssignale bezüglich aller eingespeisten Frequenzen $w_i$ und $\omega_N$ durch einen Signalgenerator (2) erzeugt werden.

22. Verfahren nach Anspruch 21, **dadurch gekennzeichnet, dass** die Hilfssignale durch eine Tiefpassfilterung eines von dem Signalgenerator (2) erzeugten Rechtecksignals, welches durch Überlagerung von Rechtecksignalen der einzelnen Frequenzen aller Frequenzanteile $\omega_i$ und $\omega_N$ gebildet wird, erzeugt werden.

23. Verfahren nach Anspruch 22, **dadurch gekennzeichnet, dass** das Rechtecksignal im Signalgenerator (2) durch das Öffnen und Schließen von Schaltern S1, S2, S3 und S4, vorzugsweise Transistoren, in den Zweigen einer H-Brücke (6) durch eine Ansteuereinheit (7) erzeugt wird und das Rechtecksignal in der Diagonale der H-Brücke (6) abgegriffen wird.

24. Verfahren nach Anspruch 23, **dadurch gekennzeichnet, dass** ein aus einer Induktivität $L_C$ und eventuell einer Kapazität $C_C$ bestehendes Tiefpassfilter (3) so dimensioniert wird, dass aus dem in der H-Brücke (6) erzeugten Rechtecksignal alle Frequenzanteile größer einer vordefinierten Eckfrequenz aus dem einzuspeisenden Hilfssignal herausgefiltert werden.

25. Vorrichtung zum selektiven Erkennen und Orten von hochohmigen einpoligen Erdfehlern in sternpunktkompensierten elektrischen Versorgungsnetzen bestehend aus einem Signalgenerator (2) zur Erzeugung zumindest eines Hilfssignals mit der Netzfrequenz $\omega_N$ und einer Regeleinheit (4) zum Erkennen und Orten von einpoligen Erdfehlern, **dadurch gekennzeichnet, dass** ein Element des Netzes, beispielsweise eine Löschspule (9), vorzugsweise eine Tauchkernspule, mit diesem Hilfssignal beaufschlagbar ist und dass der Signalgenerator (2) zur Kompensation der Sternpunkt-Verlagerungsspannung $U_{ne}(\omega_N)$ mittels des erzeugten Hilfssignals vorgesehen ist und dass die Regeleinheit (4) zur Erkennung und Ortung eines Erdfehlers bei durch das Hilfssignal kompensierter Sternpunkt-Verlagerungsspannung $U_{ne}(\omega_N)$ vorgesehen ist.

26. Vorrichtung nach Anspruch 25, **dadurch gekennzeichnet, dass** die Generierung des Hilfssignals in Form eines Stromes $i_{vC}(\omega_N)$ bei Netzfrequenz $\omega_N$ in Betrag und:Phase durch die Regeleinheit (4) so steuerbar ist, dass die Sternpunkt-Verlagerungsspannung $U_{ne}(\omega_N)$ bei Netztrrequenz $\omega_N$ kompensierbar ist.

27. Vorrichtung nach Anspruch 26, **dadurch gekennzeichnet, dass** in der Regeleinheit (4) ein Erdfehler durch Vergleich des eingespeisten Hilfssignals $i_{vC}(\omega_N)$ bei Netzfrequenz $\omega_N$ mit einer vordefinierten Fehlerschwelle erkennbar ist und ein Erdfehler anzeigbar ist, wenn im eingeregelten Zustand, $i_{vC}(\omega_N)+i_{vS}(\omega_N) = 0$, der eingespeiste Strom $i_{vC}(\omega_N)$, vorzugsweise die Amplitude, der Betrag oder der Effektivwert, diese Fehlerschwelle für eine vordehnierte Zeit überschreitet.

28. Vorrichtung nach Anspruch 26, **dadurch gekennzeichnet, dass** in der Regeleinheit (4) die komplexe Differenz zweier zeitlich aufeinanderfolgender Messungen des eingespeisten Hilfssignals $i_{vC}(\omega_N)$ bei Netzfrequenz $\omega_N$ berechenbar ist und ein Erdfehler erkennbar und anzeigbar ist, wenn im eingeregelten Zustand, $i_{vC}(\omega_N)+i_{vS}(\omega_N) = 0$, der Betrag dieser Differenz eine vordefinierte Fehlerschwelle überschreitet.

29. Vorrichtung nach Anspruch 27 oder 28, **dadurch gekennzeichnet, dass** in der Regeleinheit (4) oder einer externen Einheit der fehlerhafte Abzweig oder Leitungsabschnitt $k$ des Netzes durch Vergleich des jeweiligen gemessenen Nullstromes $i_0^{(k)}(\omega_N)$ mit einer vordefinierten Fehlerschwelle bestimmbar und anzeigbar ist.

**30.** Vorrichtung nach Anspruch 27 oder 28, **dadurch gekennzeichnet, dass** in der Regeleinheit (4) oder einer externen Einheit der fehlerhafte Abzweig oder Leitungsabschnitt $k$ des Netzes durch Bildung des Betrages einer komplexen Differenz zweier zeitlich aufeinanderfolgender Messwerte des jeweiligen gemessenen Nullstromes $i_0^{(k)}(\omega_N)$ und Vergleich mit einer vordefinierten Fehlerschwelle bestimmbar und anzeigbar ist.

**31.** Vorrichtung nach Anspruch 29 oder 30, **dadurch gekennzeichnet, dass** die Regeleinheit (4) zwischen zumindest zwei Verfahren zum Erkennen und/oder Orten von Erdfehlern hin- und herschaltbar ist.

**32.** Vorrichtung nach einem der Ansprüche 25 bis 31, **dadurch gekennzeichnet, dass** durch Messen zumindest eines weiteren eingespeisten Hilfssignals $i_{vC}(\omega_1)$, bei einer Frequenz $\omega_1$ ungleich der Netzfrequenz $\omega_N$, und der Sternpunkt-Verlagerungsspannung $U_{ne}(\omega_1)$ bei dieser Frequenz nach Betrag und Phase in der Regeleinheit (4) Netzparameter, wie beispielsweise die Admittanzsumme $[Y_S(\omega_1) + Y_L(\omega_1)]$, die Leitwertsumme $(g_S + g_L)$ oder die Summenkapazität $C_S$ des Netzes, bestimmbar sind und dass mit diesen Netzparametern die Löschspule (9) für das Netz bei Netzfrequenz $\omega_N$ abstimmbar ist.

**33.** Vorrichtung nach einem der Ansprüche 25 bis 31, **dadurch gekennzeichnet, dass** durch Messen mehrerer eingespeister Hilfssignale $i_{vC}(\omega_i)$, bei einer Frequenz $\omega_i$ ungleich der Netzfrequenz $\omega_N$, und der Sternpunkt-Verlagerungsspannung $U_{ne}(\omega_i)$ bei diesen Frequenzen nach Betrag und Phase in der Regeleinheit (4) Netzparameter, wie beispielsweise die Admittanzsumme $[Y_S(\omega_i) + Y_L(\omega_i)]$, die Leitwertsumme $(g_S + g_L)$ oder die Summenkapazität $C_S$ des Netzes, für jede Frequenz $\omega_i$ bestimmbar sind, dass aus den einzelnen Messgrößen jeder Frequenz $\omega_i$ eine bestmögliche Approximation der Netzparameter ermittelbar ist, und dass mit diesen bestapproximierten Netzparametern die Löschspule (9) für das Netz bei Netzfrequenz $\omega_N$ abstimmbar ist.

**34.** Vorrichtung nach Anspruch 32 oder 33, **dadurch gekennzeichnet, dass** aus den bei den Frequenzen $\omega_i$ ermittelten Netzparametern in der Regeleinheit (4) die erforderliche Löschspulenstellung zum Erreichen einer bestimmten kompensierten, unterkompensierten oder überkompensierten Abstimmung des Netzes berechenbar ist und dass die Löschspule (9) in diese Stellung abstimmbar ist.

**35.** Vorrichtung nach Anspruch 32 oder 33, **dadurch gekennzeichnet, dass** die Löschspule (9) mit einem Regelkreis entsprechend den berechneten Netzparametern durch die Regeleinheit (4) solange verstellbar ist, bis eine bestimmte kompensierte, unterkompensierte oder überkompensierte Abstimmung des Netzes erreicht ist.

**36.** Vorrichtung nach Anspruch 32 oder 33, **dadurch gekennzeichnet, dass** aus den ermittelten Netzparametern in der Regeleinheit (4) spezifische Kenngrößen, wie beispielsweise der Spulenstrom $i_{Lres}$ in Resonanz bei Netzfrequenz und maximaler Sternpunkt-Verlagerungsspannung $U_{ne}$ oder der Wattreststrom $i_w$ des Netzes, berechenbar und anzeigbar sind.

**37.** Vorrichtung nach einem der Ansprüche 32 bis 36, **dadurch gekennzeichnet, dass** der Signalgenerator (2) zur Erzeugung von Hilfssignalen mit einer Frequenz $\omega_i$ ungleich der Netzfrequenz $\omega_N$ derart ausgebildet ist, dass die Effektivwerte der daraus resultierenden Stempunkt-Verlagerungsspannungen $U_{ne}(\omega_i)$ bei den jeweiligen Frequenzen $\omega_i$ verhältnismäßig klein, vorzugsweise kleiner 10% des Effektivwertes der Grundwelle der Phasenspannung, gegenüber der Nennspannung des Netzes sind.

**38.** Vorrichtung nach einem der Ansprüche 25 bis 37, **dadurch gekennzeichnet, dass** der Signalgenerator als eine H-Brücke (6) mit Schaltern S1, S2, S3 und S4 in den Zweigen der H-Brücke (6) ausgebildet ist, dass die Schalter S1, S2, S3 und S4, vorzugsweise Transistoren, durch eine Ansteuereinheit (7) so ansteuerbar sind, dass ein alle einzuspeisenden Frequenzen $\omega_i$ und $\omega_N$ enthaltendes Rechtecksignal generierbar ist und dass alle Frequenzanteile größer als einer vordefinierten Eckfrequenz dieses Rechtecksignals durch ein nachgeschaltetes Tiefpassfilter (3), bestehend aus einer Induktivität $L_C$ und eventuell einer Kapazität $C_C$, herausfilterbar sind.

**39.** Vorrichtung nach einem der Ansprüche 25 bis 38, **dadurch gekennzeichnet, dass** ein Überspannungsschutz (5) vorgesehen ist, mit dem die Leistungshilfswicklung (8) der Löschspule (9) im Falle eines Erdfehlers und/oder wenn der Verlagerungsstrom $i_{vS}(\omega_N)$ einen maximal zulässigen Wert überschreitet, durch einen Schalter S5 von der Schaltung zur Generierung der Hilfssignale abtrennbar ist.

**40.** Vorrichtung nach einem der Ansprüche 25 bis 39, **dadurch gekennzeichnet, dass** als Regeleinheit (4) und/oder Ansteuereinheit (7) ein Mikrocomputer vorgesehen ist.

**Claims**

1. Method for the selective identification and localisation of high-ohm, single-pole earth faults in neutral-point compensated electrical supply networks, whereby at least one auxiliary signal with the network frequency $\omega_N$ is being supplied to the zero current system of the network, **characterised in that** the auxiliary signal is supplied in such way that the neutral point biasing voltage $U_{ne}(\omega_N)$ is substantially compensated at the network frequency $\omega_N$ and that the identification and localisation of single-pole earth faults is carried out at a compensated neutral-point biasing voltage $U_{ne}(\omega_N)$.

2. Procedure as claimed in claim 1, **characterised in that** the auxiliary signal is supplied in a continuous manner.

3. Procedure as claimed in claim 1 or 2, **characterised in that** the auxiliary signal supplied in form of a current at the network frequency, $i_{vC}(\omega_N)$, the magnitude and phase of this current $i_{vC}(\omega_N)$ being regulated by a regulating unit (4) in such way that the sum of the supplied auxiliary signal $i_{vC}(\omega_N)$ and the natural displacement current $i_{vS}(\omega_N)$ is substantially equal to zero, thus compensating the neutral-point biasing voltage $U_{ne}(\omega_N)$.

4. Procedure as claimed in claim 3, **characterised in that** the displacement current $i_{vS}(\omega_N)$ is measured indirectly by measuring the current at the network frequency, $i_{vC}(\omega_N)$, in the regulated state, $i_{vC}(\omega_N)+i_{vS}(\omega_N) = 0$, and that the measured current $i_{vC}(\omega_N)$ is used to identify an earth-fault in the overall network.

5. Procedure as claimed in claim 4, **characterised in that** an earth-fault can be identified and displayed when the measurement of the current to be supplied at the network frequency, $i_{vC}(\omega_N)$, indicated preferably by its amplitude, magnitude or root mean square value, strongly increases and exceeds a predefined error threshold for a predefined period of time.

6. Procedure as claimed in claim 4, **characterised in that** an earth-fault can be identified and displayed when the magnitude of the complex measurement of two chronologically successive measurements of the current to be supplied at the network frequency, $i_{vC}(\omega_N)$, strongly increases and exceeds a predefined error threshold.

7. Procedure as claimed in claim 5 or 6, **characterised in that** by measuring the zero current $i_0^{(k)}(\omega_N)$ in the regulated state, that is, when $U_{ne}(\omega_N)=0$, the sum of the natural displacement current $i_v^{(k)}(\omega_N)$ and an eventually available residual current from the respective $k^{th}$ branch or line section is measured directly from each network branch or line section k at the network frequency $\omega_N$ and that these zero currents $i_0^{(k)}(\omega_N)$ are utilised to locate the faulty network branch of line section and/or the faulty location within this branch or line section.

8. Procedure as claimed in claim 7, **characterised in that** for one branch or line section f the corresponding zero current $i_0^{(f)}(\omega_N)$, preferably its amplitude, magnitude or the root mean square is compared with a predefined error threshold and identified and displayed as faulty when the magnitude of the complex zero current vector $i_0^{(f)}(\omega_N)$ exceeds this error threshold for a predetermined period of time.

9. Procedure as claimed in claim 7, **characterised in that** for one branch or line section f the complex difference of two chronologically successive measurements of the corresponding zero current $i_0^{(f)}(\omega_N)$ is made, the magnitude of this difference is compared to a predefined error threshold, and a faulty branch or line section is identified and displayed, if the magnitude of this difference exceeds this error threshold.

10. Procedure as claimed in claim 8 or 9, **characterised in that** in case of exceeding a predetermined value of the current $i_{vC}(\omega_N)$ to be supplied, a different method for identifying and/or localising earth-faults is utilised.

11. Procedure as claimed in one of the claims 1 to 10, **characterised in that** at least one further auxiliary signal with a frequency $\omega_i$ unequal to the network frequency $\omega_N$ is supplied and that this auxiliary signal is utilised for tuning an earth-fault neutraliser (9) of the supply network at the network frequency $\omega_N$.

12. Procedure as claimed in claim 11, **characterised in that** the additional auxiliary signal $i_{vC}(\omega_i)$ supplied in form of an electric current and the magnitude and phase of the neutral-point biasing voltage $U_{ne}(\omega_N)$ generated therefrom are continuously measured relative to a frequency $\omega_i$ unequal to the network frequency $\omega_N$, for example $\omega_i = \omega_N/2$ oder $\omega_i = 3\omega_N/2$, and that by forming the ratio between $i_{vC}(\omega_i)$ and $U_{ne}(\omega_i)$ the total admittance is determined from the earth admittance of all network branches or line sections $Y_S(\omega_i)$ and the admittance of the earth-fault neutraliser $Y_L(\omega_i)$ is obtained from the relation

$$-i_{vC}(\omega_i) / U_{ne}(\omega_i) = [Y_S(\omega_i)+Y_L(\omega_i)].$$

**13.** Procedure as claimed in claim 12, **characterised in that** by splitting the relation

$$[Y_s(\omega_i)+Y_L(\omega_i)] = (g_s + g_L) + j(\omega_i C_S - 1/\omega_i L)$$

into a real and an imaginary part and by taking into account the known inductivity L of the earth-fault neutraliser (9) from the equation

$$C_S = 1/\omega_i \{Im[Y_S(\omega_i)+Y_L(\omega_i)] + 1/\omega_i L\}$$

the total capacitance $C_s$ of the whole network and/or from the equation

$$(g_S + g_L) = Re[Y_S(\omega_i)+Y_L(\omega_i)]$$

the total susceptance is obtained from the total conductance g, and the conductance $g_L$ of the earth-fault neutraliser (9).

**14.** Procedure as claimed in claims 12 and 13 **characterised in that** a plurality of currents $i_{vC}(\omega_i)$ are supplied with frequencies different to the network frequency $\omega_N$ and different to one another, that the required network parameters, in particular $[Y_s(\omega_i)+Y_L(\omega_i)]$, C, and $(g_s + g_L)$, are determined for each individual frequency $\omega_i$, and that the measurements of each individual frequency are used to obtain a best possible approximation of the network parameters with any suitable method.

**15.** Procedure as claimed in one of the claims 11 to 14, **characterised in that** the magnitudes of the currents $i_{vC}(\omega_i)$ supplied at a frequency $\omega_i$ unequal to the network frequency $\omega_N$ are selected so that the root mean square values of the resulting neutral-point biasing voltages $U_{ne}(\omega_i)$ are relatively small at the individual frequencies $\omega_i$ and preferably smaller than 10% of the root mean square value of the fundamental phase voltage of the network.

**16.** Procedure as claimed in one of the claims 11 to 15, **characterised in that** the frequencies $\omega_i$ are selected so that the fundamental wave component and the harmonic wave components of the frequency spectra of all the supplied signals with fundamental frequencies $\omega_i$ und $\omega_N$ do not overlap.

**17.** Procedure as claimed in claim 12, 13 or 14, **characterised in that** the earth-fault neutraliser (9) is tuned for the network with the network frequency $\omega_N$.

**18.** Procedure as claimed in claim 17, **characterised in that** by way of the total capacitance $C_s$ of the overall network the resonance point at the network frequency $\omega_N$ can be determined according to the known resonance equation

$$Im[Y_S(\omega_i)+Y_L(\omega_i) = 0 \Rightarrow \omega_N C_s = 1/\omega_N L$$

and that the inducdvity L of the earth-fault neutraliser (9) can be obtained from the resonance equation so that the desired compensated, undercompensated or overcompensated tuning of the earth-fault neutraliser (9) is achieved.

**19.** Procedure as claimed in claim 17, **characterised in that** a regulating unit (4) adjusts the inductivity of the earth-fault neutraliser (9) until the desired compensated, undercompensated or overcompensated tuning of the earth-fault neutraliser (9) is achieved.

**20.** Procedure as claimed in one of the claims 12, 13 or 14, **characterised in that** the obtained supply network parameters can be used to calculate and display specific characteristic values, such as the coil current $i_{Lres}$, the earth-fault neutraliser current in resonance at the network frequency and the neutral-point biasing voltage $U_{ne}$ equal to the fundamental phase voltage, or the residual current per watt $i_w$ of the network.

**21.** Procedure as claimed in one of the claims I to 20, **characterised in that** the auxiliary signals are generated with a signal generator (2) in relation to all the supplied frequencies $\omega_i$ and $\omega_N$.

**22.** Procedure as claimed in claim 21, **characterised in that** the auxiliary signals are generated by passing a square wave generated by the signal generator (2) through a low pass filter, said square wave being created by overlapping the square waves from the individual frequencies of all the frequency components $\omega_i$ und $\omega_N$.

**23.** Procedure as claimed in claim 22, **characterised in that** the square wave is generated in the signal generator (2) by the opening and closing of switches S1, S2, S3 and S4 on the branches of an H-bridge (6), the switches being preferably transistors controlled by a control unit (7) and that the square wave is tapped at the diagonal part of the H-bridge (6).

**24.** Procedure as claimed in claim 23, **characterised in that** a low pass filter (3) comprising an inductance $L_c$ and possibly a capacity $C_c$ are dimensioned so that all the frequency components of the square wave generated in the H-bridge (6) which exceed a predefined cut-off frequency are filtered from the auxiliary signal to be supplied.

**25.** Device for the selective identification and localisation of high-ohm, single-pole earth faults in neutral-point compensated electrical supply networks comprising a signal generator (2) for generating at least one auxiliary signal with the network frequency $\omega_N$ and a regulating unit (4) for identifying and locating single-pole earth faults, **characterised in that** one element of the network, for example an earth-fault neutraliser (9), preferably a moving coil reactor, can be supplied with this auxiliary signal and that the signal generator (2) is provided for compensating the neutral-point biasing voltage $U_{ne}(\omega_N)$ using the generated auxiliary signal and that the regulation unit (4) is provided for identifiying and localising earth faults at the compensated neutral-point biasing voltage.

**26.** Device as claimed in claim 25, **characterised in that** the generation of the auxiliary signal in form of a current $i_{vC}(\omega_N)$ at the network frequency $\omega_N$ of magnitude and phase regulated by the regulating unit (4) can be controlled so that the neutral-point biasing voltage $U_{ne}(\omega_N)$ can be compensated at the network frequency $\omega_N$.

**27.** Device as claimed in claim 26, **characterised in that** in the control unit (4) an earth fault can be identified by comparing the supplied auxiliary signal $i_{vC}(\omega_N)$ at the network frequency $\omega_N$ with a predefined error threshold and that an earth fault can be displayed if, in the regulated state $i_{vC}(\omega_N)+i_{vS}(\omega_N) = 0$, preferably the amplitude, magnitude or root mean square value of the supplied current $i_{vC}(\omega_N)$ exceeds this error threshold for a predefined period of time.

**28.** A device as claimed in claim 26, **characterised in that** in the control unit (4) the complex difference of two consecutive measurements of the auxiliary signal $i_{vC}(\omega_N)$ fed therein at the network frequency $\omega_N$ can be calculated and that an earth fault can be identified and localised when in the adjusted state $i_{vC}(\omega_N)+i_{vS}(\omega_N) = 0$ the value of this difference exceeds a predefined error threshold.

**29.** A device as claimed in claims 27 or 28, **characterised in that** in the control unit (4) or in an external unit the faulty breakout or line segment k in the network can be identified and localised by comparing the individually measured zero current $i_0^{(k)}(\omega_N)$ with a predefined error threshold.

**30.** A device as claimed in claims 27 or 28, **characterised in that** in the control unit (4) or in an external unit the faulty breakout or line segment k in the network can be identified and localised by calculating the value obtained from the complex difference of two consecutive measurements of the individually measured zero current $i_0^{(k)}(\omega_N)$ and comparing it with a predefined error threshold.

**31.** A device as claimed in claims 29 or 30, **characterised in that** the control unit (4) can be switched between at least two methods to identify and/or localise earth faults.

**32.** A device as claimed in claims 25 to 31, **characterised in that** by measuring at least one further supplied auxiliary signal $i_{vC}(\omega_i)$ at a frequency $\omega_1$ unequal to the network frequency $\omega_N$, and the neutral-point biasing voltage $U_{ne}(\omega_i)$ at this frequency in the regulating unit (4), the magnitudes and phase of network parameters such as the total admittance $[Y_s(\omega_i)+Y_L(\omega_i)]$, the total susceptance $(g_s + g_L)$ or the total capacitance C, of the network can be established and that these network parameters can be used to tune the earth-fault neutraliser (9) to the supply network at the network frequency $\omega_N$.

**33.** A device as claimed in claims 25 to 31, **characterised in that** by measuring a plurality of supplied auxiliary signals $i_{vC}(\omega_i)$ at a frequency $\omega_i$ unequal to the network frequency $\omega_N$, and the neutral-point biasing voltage $U_{ne}(\omega_i)$ at these frequencies in the regulating unit (4), the magnitudes and phase of network parameters such as the total admittance $[Y_s(\omega_i)+Y_L(\omega_i)]$, the total susceptance $(g_s + g_L)$ or the total capacitance C, of the network can be established for each frequency $\omega_i$, that each measured frequency value $\omega_i$ can be used to obtain a best possible approximation of the network parameters and that these best possible approximated network parameters can be used to tune the earth-fault neutraliser (9) for the supply network at the network frequency $\omega_N$.

**34.** A device as claimed in claims 32 or 33, **characterised in that** the network parameters in the regulating unit (4) obtained at the frequencies $\omega_i$ are used to calculate the required earth-fault neutraliser position to obtain a specific compensated, undercompenaated or overcompensated tuning of the supply network and that the earth-fault neutraliser (9) can be tuned in this position.

**35.** A device as claimed in claims 32 or 33, **characterised in that** the earth-fault neutraliser (9) can be adjusted by the regulating unit (4) using a regulating circuit in accordance with the calculated network parameters until a specific compensated, undercompensated or overcompensated tuning of the supply network is obtained.

**36.** A device as claimed in claims 32 or 33, **characterised in that** the obtained supply network parameters can be used to calculate and display specific characteristic values in the regulating unit (4), such as the coil current $i_{Lres}$ in resonance at the network frequency and the maximum neutral-point biasing voltage $U_{ne}$ or the residual current per watt $i_w$ of the network.

**37.** A device as claimed in claims 32 to 36, **characterised in that** the signal generator (2) for generating auxiliary signals with a frequency $\omega_i$ unequal to the network frequency $\omega_N$ is constructed in such way that the root mean square values from the resulting neutral-point biasing voltages $U_{ne}(\omega_i)$ are relatively small at the individual frequencies $\omega_i$ and preferably smaller than 10% of the root mean square value of the fundamental phase voltage in relation to the nominal network voltage.

**38.** A device as claimed in claims 25 to 37, **characterised in that** the signal generator is constructed as an H-bridge (6) with switches S1, S2, S3 and S4 on the branches of said H-bridge (6), the switches S1, S2, S3 and S4 being preferably transistors that are controlled by a control unit (7) so as to generate a square wave containing all the frequencies $\omega_i$ and $\omega_N$ to be supplied and that all frequency components larger than a predefined cut-off frequency of this square wave can be filtered out by a low pass filter (3) connected downstream comprising an inductance $L_c$ and possibly a capacity $C_c$.

**39.** A device as claimed in claims 25 to 38, **characterised in that** it comprises an overvoltage protector (5) enabling the auxiliary power coil (8) of the earth-fault neutraliser (9) to be isolated by a switch S5 from the circuit generating the auxiliary signals in case of an earth fault and/or when the displacement current $i_{vS}(\omega_N)$ exceeds a permitted maximum value.

**40.** A device as claimed in claims 25 to 39, **characterised in that** the regulation unit (4) and/or the control unit (7) is provided by microcomputer.

**Revendications**

**1.** Procédé d'identification et de localisation sélective de défauts à la terre monopolaires à valeur ohmique élevée, dans des réseaux d'alimentation électrique à compensation du point neutre, dans lequel, dans le système neutre du réseau, au moins un signal auxiliaire, ayant la fréquence de réseau $\omega_N$, est injecté, **caractérisé en ce que** le signal auxiliaire est injecté de manière que, de ce fait, la tension de décalage de point neutre $U_{ne}(\omega_N)$ à la fréquence de réseau $\omega_N$ soit pratiquement compensée, et que le défaut à la terre soit identifié et localisé, pour une tension de décalage de point neutre $U_{ne}(\omega_N)$ compensée par le signal auxiliaire.

**2.** Procédé selon la revendication 1, **caractérisé en ce que** le signal auxiliaire est injecté en continu.

**3.** Procédé selon la revendication 1 ou 2, **caractérisé en ce que** le signal auxiliaire, injecté à la forme d'un courant, à la fréquence de réseau $i_{vC}(\omega_N)$ est commandé, en amplitude et en phase, par une unité de régulation (4), de manière que la somme, formée de ce signal auxiliaire $i_{vC}(\omega_N)$ injecté et du courant de décalage naturel $i_{vC}(\omega_N)$, soit sensiblement égale à zéro et que, de ce fait, la tension de décalage de point neutre $U_{ne}(\omega_N)$ soit compensée.

**4.** Procédé selon la revendication 3, **caractérisé en ce que**, par la mesure du courant injecté, à la fréquence de réseau $i_{vC}(\omega_N)$, à l'état réglé, $i_{vC}(\omega_N) + i_{vS}(\omega_N) = 0$, le courant de décalage $i_{vS}(\omega_N)$ est mesuré de façon indirecte et **en ce qu'**un défaut à la terre, dans le réseau global, est identifié à l'aide de ce courant $i_{vC}(\omega_N)$ mesuré.

**5.** Procédé selon la revendication 4, **caractérisé en ce qu'**un défaut à la terre est identifié et affiché lorsque la valeur de mesure du courant à injecter, à la fréquence de réseau $i_{vC}(\omega_N)$, de préférence, l'amplitude, la valeur ou la valeur effective, augmente fortement et dépasse, pendant une durée prédéfinie, une valeur de seuil de défaut prédéfinie.

**6.** Procédé selon la revendication 4, **caractérisé en ce qu'**un défaut à la terre est identifié et affiché si la valeur de la différence complexe de deux mesures successives temporellement du courant à injecter, à la fréquence de réseau $i_{vC}(\omega_N)$, augmente fortement et dépasse un seuil de défaut prédéfini.

**7.** Procédé selon la revendication 5 ou 6, **caractérisé en ce que**, par mesure du courant neutre $i_0^{(k)}(\omega_N)$ à l'état réglé, donc pour $U_{ne}(\omega_N) = 0$, de chaque ramification ou tronçon de ligne k du réseau, à la fréquence de réseau $\omega_N$, directement la somme, issue du courant de décalage naturel $i_0^{(k)}(\omega_N)$ et d'un éventuel courant de réseau existant, de chaque fois la kième dérivation ou tronçon de ligne, pour la fréquence de réseau, est mesurée, et **en ce que** ces courants neutres $i_0^{(k)}(\omega_N)$ sont utilisés pour localiser la ramification défectueuse ou le tronçon de ligne défectueux du réseau et/ou l'emplacement défectueux à l'intérieur de cette ramification ou de ce tronçon de ligne.

**8.** Procédé selon la revendication 7, **caractérisé en ce que**, pour une ramification ou un tronçon de ligne *f*, le courant neutre $i_0^{(f)}(\omega_N)$ afférent, de préférence, l'amplitude, la valeur ou la valeur effective est comparé à un seuil d'erreur prédéfini et identifié et affiché comme défectueux si la valeur du vecteur de courant neutre, complexe, $i_0^{(f)}(\omega_N)$ dépasse ce seuil d'erreur pour une durée prédéfinie.

**9.** Procédé selon la revendication 7, **caractérisé en ce que**, pour une ramification ou un tronçon de ligne *f*, de deux mesures temporellement successives, le courant neutre $i_0^{(f)}(\omega_N)$ afférent, on forme la différence complexe, on compare la valeur de cette différence à un seuil d'erreur prédéfini et on identifie et on affiche une ramification ou un tronçon de ligne défectueux si la valeur de la différence dépasse ce seuil d'erreur.

**10.** Procédé selon la revendication 8 ou 9, **caractérisé en ce que**, en cas de dépassement d'une grandeur, prédéterminée, du courant $i_{vC}(\omega_N)$ à injecter, on commute sur un autre procédé approprié d'identification et/ou de localisation des défauts à la terre.

**11.** Procédé selon l'une des revendications 1 à 10, **caractérisé en ce qu'**au moins un autre signal auxiliaire, d'une fréquence $\omega_i$, différente de la fréquence de réseau $\omega_n$, est injecté, et **en ce que** ce signal auxiliaire est utilisé pour accorder une bobine de soufflage (9) du réseau à la fréquence de réseau $\omega_N$.

**12.** Procédé selon la revendication 11, **caractérisé en ce que** l'autre signal auxiliaire $i_{vC}(\omega_1)$, injecté sous la forme d'un courant électrique, et la tension de décalage de point neutre $U_{ne}(\omega_1)$ produite à partir de cela, par rapport à une fréquence $\omega_1$, différente de la fréquence de réseau $\omega_n$, par exemple $\omega_1 = \frac{\omega_N}{2}$ ou $\omega_1 = \frac{3\omega_N}{2}$, est mesurée en continu en intensité et en phase et **en ce que**, par formation d'un quotient, entre $i_{vC}(\omega_1)$ et $U_{ne}(\omega_1)$, on détermine la somme d'admittance à partir de l'admittance de terre de toutes les ramifications ou tronçons de ligne du réseau

$Y_S(\omega_1)$ et l'admittance de bobines de soufflage $Y_L(\omega_1)$, à partir de la relation $-\dfrac{i_{vC}(\omega_1)}{U_{ne}(\omega_1)} = [Y_S(\omega_1)+Y_L(\omega_1)]$.

**13.** Procédé selon la revendication 12, **caractérisé en ce qu'**en décomposant la relation :

$$[Y_S(\omega_1) + Y_L(\omega_1)] = (g_S + g_L) + j\omega_1 C_S - \frac{1}{\omega_1 L}$$

en partie réelle et en partie imaginaire, et en se basant sur l'inductance L connue de la bobine de soufflage (9), à partir de l'équation $C_S = \dfrac{1}{\omega_1} \cdot \{\mathrm{Im}[Y_S(\omega_1) + Y_L(\omega_1)] + \dfrac{1}{\omega_1 L}\}$,

on détermine la capacité somme $C_s$ du réseau global, et/ou, à partir de l'équation $(g_S + g_L) = [Y_S(\omega_1) + Y_L(\omega_1)]$, on détermine la somme de valeur de la conductrice à partir de la valeur conductrice de somme $g_s$ du réseau global et de la valeur conductrice de bobine $g_L$ de la bobine de soufflage (9).

**14.** Procédé selon les revendications 12 et 13, **caractérisé en ce qu'**une pluralité de courants $i_{vC}(\omega_i)$, ayant des fréquences $\omega_i$ différentes de la fréquence de réseau $\omega_N$ et différentes entre elles, sont injectés, **en ce que** le paramètre de réseau nécessaire, en particulier $[Y_S(\omega_i) + Y_L(\omega_i)]$, $C_S$ et $(g_S + g_L)$ sont déterminées pour chaque fréquence $\omega_i$ et **en ce que**, à partir des valeurs de mesures de chaque fréquence $\omega_i$, avec une méthode quelconque, on détermine une approximation la meilleure possible des paramètres de réseau.

**15.** Procédé selon l'une des revendications 11 à 14, **caractérisé en ce que** les valeurs des courants $i_{vC}(\omega_i)$, à une fréquence $\omega_i$, différente de la fréquence de réseau $\omega_N$, sont choisies de manière que les valeurs efficaces des tensions de décalage de point neutre $U_{ne}(\omega_i)$ en résultant, pour la fréquence $\omega_i$ respective, soient relativement petites, de préférence inférieures à 10 % de la valeur efficace de l'onde fondamentale de la tension nominale de phase du réseau.

**16.** Procédé selon l'une des revendications 11 à 15, **caractérisé en ce que** les fréquences $\omega_i$ sont choisies telles que les proportions d'ondes fondamentales, ainsi que les proportions d'harmonique des spectres de fréquence de tous les signaux injectés, ne coupent pas les fréquences d'ondes fondamentales $\omega_i$ et $\omega_N$.

**17.** Procédé selon la revendication 12, 13 ou 14, **caractérisé en ce que**, avec les paramètres de réseau déterminés, on accorde la bobine de soufflage (9) pour le réseau, à la fréquence de réseau $\omega_N$.

**18.** Procédé selon la revendication 17, **caractérisé en ce qu'**avec la capacité somme $S_N$ du réseau global, le point de résonance à la fréquence de réseau $\omega_N$, est déterminé selon la relation de résonance $\mathrm{Im}[Y_S(\omega_N) + Y_L(\omega_N)]$ $=0 \Rightarrow \omega_N C_S = \dfrac{1}{\omega_N L}$, et **en ce que** l'inductance de la bobine de soufflage (9) est déterminée, de manière correspondante à la relation de résonance, et réglée de manière que l'accord compensé souhaité, sous-compensé ou sur-compensé, de la bobine de soufflage (9) soit atteint.

**19.** Procédé selon la revendication 17, **caractérisé en ce qu'**une unité de régulation (4) règle l'inductance de la bobine de soufflage (9), avec un circuit de régulation propre, jusqu'à ce que l'accord souhaité compensé, sous-compensé ou sur-compensé, de la bobine de soufflage (9) soit atteint.

**20.** Procédé selon l'une des revendications 12, 13 ou 14, **caractérisé en ce que**, à partir des paramètres de réseau déterminés, on calcule et on affiche des grandeurs caractéristiques spécifiques, telles que par exemple le courant de bobine $i_{Lres}$, donc le courant de bobine de soufflage, en résonance à la fréquence de réseau, et la tension de décalage de point neutre $U_{ne}$, identique à la tension nominale de phase, ou le courant résiduel de Watt $i_w$ du réseau.

**21.** Procédé selon l'une des revendications 1 à 20, **caractérisé en ce que** les signaux auxiliaires concernant toutes les fréquences $\omega_i$ et $\omega_N$ injectées sont produits par un générateur de signal (2).

**22.** Procédé selon la revendication 21, **caractérisé en ce que** les signaux auxiliaires sont produits par un filtrage passe-bas d'un signal rectangulaire, produit par le générateur de signal (2), qui est formé par superposition de signaux rectangulaires des différentes fréquences de toutes les parties de fréquence concernant toutes les fréquences $\omega_i$ et $\omega_N$.

**23.** Procédé selon la revendication 22, **caractérisé en ce que** le signal rectangulaire, dans le générateur de signal (2), est produit par ouverture et fermeture d'interrupteurs S1, S2, S3 et S4, de préférence, de transistors dans les branches d'un pont en H (6) par une unité d'attaque (7) et le signal rectangulaire est prélevé dans la diagonale du pont (6).

**24.** Procédé selon la revendication 23, **caractérisé en ce qu'**un filtre passe-bas (3), formé d'une inductance $L_c$ et, éventuellement, d'une capacité $C_c$, est dimensionné de manière que, à partir du signal rectangulaire produit dans le pont en H (6), toutes les proportions de fréquence supérieures à une fréquence de cassure prédéfinie soient éliminées du signal auxiliaire à injecter, par filtrage.

**25.** Dispositif d'identification et de localisation sélective de défauts à la terre monopolaires fortement ohmique, dans des réseaux d'alimentation électrique à compensation du point neutre, formé d'un générateur de signal (2), pour générer au moins un signal auxiliaire à la fréquence de réseau $\omega_N$, et d'une unité de régulation (4) pour identifier et localiser des défauts à la terre monopolaires, **caractérisé en ce qu'**un élément du réseau, par exemple une bobine de soufflage (9), de préférence une bobine à noyau plongeur, est susceptible d'être sollicité par ce signal auxiliaire, et **en ce que** le générateur de signal (2) est prévu pour la compensation de la tension de décalage du point neutre $U_{ne}(\omega_N)$, au moyen du signal auxiliaire généré, et **en ce que** l'unité de régulation (4) est prévue pour identifier et localiser des défauts à la terre pour une tension de décalage de point neutre par le signal auxiliaire.

**26.** Dispositif selon la revendication 25, **caractérisé en ce que** la génération du signal auxiliaire, sous la forme d'un courant $i_{vC}(\omega_N)$, à la fréquence de réseau $\omega_N$, peut être commandée, en intensité et en phase, par l'unité de régulation (4), de manière que la tension de décalage du point neutre $U_{ne}(\omega_N)$, à la fréquence de réseau $\omega_N$, puisse être compensée.

**27.** Dispositif selon la revendication 26, **caractérisé en ce que**, dans l'unité de régulation (4), un défaut à la terre est identifiable par comparaison entre le signal auxiliaire $i_{vC}(\omega_N)$ injecté, à la fréquence de réseau $\omega_N$, avec un seuil de défaut prédéfini, et un défaut à la terre est affichable lorsque, à l'état réglé, $i_{vC}(\omega_N) + i_{vS}(\omega_N) = 0$, le courant $i_{vC}(\omega_N)$ injecté, de préférence l'amplitude, la valeur ou la valeur efficace, dépasse ce seuil de défaut pour une durée prédéfinie.

**28.** Dispositif selon la revendication 26, **caractérisé en ce que**, dans l'unité de régulation (4), la différence complexe, entre deux mesures temporellement successives, du signal auxiliaire $i_{vC}(\omega_N)$ injecté, à la fréquence de réseau $\omega_N$, peut être calculée et un défaut à la terre peut être identifié et affiché si, à l'état réglé, $i_{vC}(\omega_N) + i_{vS}(\omega_N) = 0$, la valeur de cette différence dépasse un seuil de défaut prédéfini.

**29.** Dispositif selon la revendication 27 ou 28, **caractérisé en ce que**, dans l'unité de régulation (4), ou une unité externe, la ramification défectueuse ou le tronçon de ligne k défectueux du réseau peut être déterminé(e) et affiché(e) par comparaison entre le courant neutre $i_0^{(k)}(\omega_N)$ chaque fois mesuré et un seuil de défaut prédéfini.

**30.** Dispositif selon la revendication 27 ou 28, **caractérisé en ce que** dans l'unité de régulation (4), ou une unité externe, la ramification défectueuse ou le tronçon de ligne k défectueux du réseau peut être déterminé(e) et affiché(e) par formation de la valeur d'une différence complexe entre deux valeurs de mesure, temporellement successives, du courant neutre $i_0^{(k)}(\omega_N)$ mesuré respectif et comparaison à un seuil de défaut prédéterminé.

**31.** Dispositif selon la revendication 29 ou 30, **caractérisé en ce que** l'unité de régulation (4) peut être commutée dans un sens et retour, entre au moins deux procédés d'identification et/ou de localisation de défaut à la terre.

**32.** Dispositif selon l'une des revendications 25 à 31, **caractérisé en ce que**, par mesure d'au moins un autre signal auxiliaire $i_{vC}(m_1)$ injecté à une fréquence $\omega_1$, différente de la fréquence de réseau $\omega_N$, et la tension de décalage du point neutre $U_{ne}(\omega_1)$ à cette fréquence, en intensité et en phase, dans l'unité de régulation (4) des paramètres de réseau, tels que, par exemple, la somme d'admittance $[Y_S(\omega_1) + Y_L(\omega_1)]$, la somme de conductances $(g_S+g_L)$ ou la capacité $C_S$ sont susceptibles d'être déterminés, **en ce que** la bobine de soufflage (9) pour le réseau peut être accordée à la fréquence de réseau $\omega_N$ à l'aide de ces paramètres de réseau.

**33.** Dispositif selon l'une des revendications 25 à 31, **caractérisé en ce que**, par mesure d'une pluralité de signaux auxiliaires $i_{vC}(\omega_i)$ injecté, à une fréquence $\omega_i$ différente de la fréquence de réseau $\omega_N$, et de la tension de décalage du point neutre $U_{ne}(\omega_i)$ pour ces fréquences, en intensité et en phase, dans l'unité de régulation (4) peuvent être déterminées des paramètres de réseau, tels que, par exemple, la somme d'admittance $[Y_S(\omega_i) + Y_L(\omega_i)]$, la somme de conductances $(g_S + g_L)$, ou la capacité somme $C_s$ du réseau, pour chaque $\omega_i$, **en ce que**, à partir des différentes grandeurs de mesures de chaque fréquence $\omega_i$, une meilleure approximation possible des paramètres de réseau peut être déterminée, et **en ce que**, à l'aide de ces paramètres de réseau à la meilleure approximation possible, la bobine de soufflage (9) pour le réseau peut être accordée à la fréquence de réseau $\omega_N$.

**34.** Dispositif selon la revendication 32 à 33, **caractérisé en ce que**, à partir des deux paramètres de réseau déterminés, aux fréquences $\omega_1$, dans l'unité de régulation (4), le réglage de bobine de soufflage nécessaire, pour atteindre un accord compensé déterminé sur-compensé ou sous-compensé du réseau, peut être calculé, et **en ce que** le bobine de soufflage (9) peut être accordée à cette position.

**35.** Dispositif selon la revendication 32 ou 33, **caractérisé en ce que** le bobine de soufflage (9) peut être réglée à l'aide d'un circuit de régulation, de manière correspondante aux paramètres de réseau calculés, au moyen de l'unité de régulation (4), jusqu'à ce qu'un accord compensé déterminé, sur-compensé ou sous-compensé, du réseau soit atteint.

**36.** Dispositif selon les revendications 32 et 33, **caractérisé en ce que**, à partir des paramètres de réseau déterminés, dans l'unité de régulation (4), des grandeurs caractéristiques spécifiques, telles que par exemple le courant de bobine $i_{Lres}$ en résonance à la fréquence de réseau, et la tension de décalage de point neutre maximal $U_{ne}$ ou le courant résiduel de Watt $i_w$ du réseau, peuvent être calculées et affichées.

**37.** Dispositif selon l'une des revendications 32 à 36, **caractérisé en ce que** le générateur de signal (2), pour produire des signaux auxiliaires à une fréquence $\omega_i$ différente de la fréquence de réseau $\omega_N$, est réalisé de manière que les valeurs effectives des tensions de décalage du point neutre $U_{ne}(\omega_i)$ en résultant, pour les fréquences $\omega_i$ respectives, soient relativement petites, de préférence, inférieures à 10% de la valeur efficace de l'onde de base de la tension de phase, par rapport à la tension nominale.

**38.** Dispositif selon l'une des revendications 25 à 37, **caractérisé en ce que** le générateur de signal est réalisé sous la forme d'un pont en H (6) avec des interrupteurs S1, S2, S3 et S4 dans les ramifications du pont en H (6), **en ce que** les interrupteurs S1, S2, S3 et S4, de préférence des transistors, sont susceptibles d'être commandés par une unité d'attaque (7), de manière qu'un signal rectangulaire, contenant toutes les fréquences $\omega_i$ et $\omega_N$ à injecter, puisse être généré et que toutes les proportions de fréquence, supérieures à une fréquence de cassure prédéfinie de ce signal rectangulaire, puisse être éliminées par filtrage, au moyen d'un filtre passe-bas (3) branché en aval, formé d'une inductance $N_c$ et, éventuellement, d'une capacité $C_c$.

**39.** Dispositif selon l'une des revendications 25 à 38, **caractérisé en ce qu'**une protection de surtension (5) est prévue, à l'aide de laquelle l'enroulement auxiliaire de puissance (8) de la bobine de soufflage (9), dans le cas d'un défaut à la terre et/ou lorsque le courant de décalage $i_{vS}(\omega_N)$ dépasse une valeur admissible maximale, peut être séparé du circuit de génération des signaux auxiliaires, au moyen d'un interrupteur S5.

**40.** Dispositif selon l'une des revendications 25 à 39, **caractérisé en ce qu'**un micro-ordinateur est prévu comme unité de régulation (4) et/ou unité d'attaque (7).

Fig. 1

**Fig. 2**

PFC
Power Factor Correction

220VAC/50Hz

+400VDC

S1  S2  S3  S4  S5

Lc

Cc

Überspannungs-Überwachung

zum Sternpunkt Transformator

Ansteuereinheit

Regeleinheit

Une

1  2  3  4  5  6  7  8  9

# Fig. 3